# EUROPEAN PATENT APPLICATION

(11) **EP 1 069 625 A2**
(43) Date of publication of application: **17.01.2001**
(21) Application number: 00115235.4
(22) Date of filing: 13.07.2000
(51) Int. Cl.: H01L 31/075, H01L 31/18, H01L 31/20, H01L 31/0368, H01L 31/048

(54) **Microcrystalline series photovoltaic element, process for the production of said photovoltaic element, building material and power generation apparatus in which said photovoltaic element is used**

(30) Priority: 14.07.1999 JP 19984699
(71) Applicant: CANON KABUSHIKI KAISHA, Ohta-ku, Tokyo (JP)
(72) Inventor: Shiozaki, Atushi, Ohta-ku, Tokyo (JP); Sano, Masafumi, Ohta-ku, Tokyo (JP); Kariya, Toshimitsu, Ohta-ku, Tokyo (JP); Kondo, Takaharu, Ohta-ku, Tokyo (JP); Higashikawa, Makoto, Ohta-ku, Tokyo (JP)
(74) Representative: Leson, Thomas Johannes Alois, Dipl.-Ing.

(57) **Abstract**

A photovoltaic element having a stacked structure comprising a first semiconductor layer containing no crystalline phase, a second semiconductor layer containing approximately spherical microcrystalline phases, and a third semiconductor layer containing pillar microcrystalline phases which are stacked in this order, wherein said spherical microcrystalline phases of said second semiconductor layer on the side of said third semiconductor layer have an average size which is greater than that of said spherical microcrystalline phases of said second semiconductor layer on the side of said first semiconductor layer.

## Description

### BACKGROUND OF THE INVENTION

### 1. Field of the Invention

The present invention relates to a microcrystalline series photovoltaic element having a high photoelectric conversion efficiency and which enables one to produce a high performance semiconductor device, representatively such as a high performance solar cell, a high performance photosensor, or the like, where particularly said solar cell stably exhibits solar cell characteristics without being deteriorated even when continuously used outdoors over a long period of time. The present invention also relates a process for producing said photovoltaic element. The present invention further relates to a building material in which said photovoltaic element is used and a sunlight power generation apparatus in which said photovoltaic element is used.

### 2. Related Background Art

Various photovoltaic elements have been using not only as independent power sources of electrical equipments but also as alternate energy sources of daily power supply systems. However, for the photovoltaic elements used as alternate energy sources of daily power supply systems, they are still unsatisfactory particularly in terms of their cost per a unit quantity of generated power. In this connection, various Studies have been conducting in order to develop improved photovoltaic elements. For instance, particularly with respect to the materials which play the most important role in photoelectric conversion, technical research and development of crystalline type photovoltaic elements, thin film type photovoltaic elements, and the like have been carrying out. The crystalline type photovoltaic element is meant a photovoltaic element having a photoelectric conversion member comprising a single crystalline silicon semiconductor material or a polycrystalline silicon semiconductor material. The thin film type photovoltaic element is meant a photovoltaic element having a photoelectric conversion member comprising an amorphous silicon-containing semiconductor material such as an amorphous silicon semiconductor material and an amorphous silicon-germanium semiconductor material; a microcrystalline silicon-containing semiconductor material such as a microcrystalline silicon semiconductor material and a microcrystalline silicon-germanium semiconductor material; an amorphous or microcrystalline silicon carbide semiconductor material; or a compound semiconductor material. For such microcrystalline silicon-containing semiconductor material, although various studies have been made, its reduction to practical use has not progressed as in the case of the crystalline or amorphous semiconductor materials.

Now, attention has been focused on a report by J. Meier et als., stating that a photovoltaic element (a solar cell) in which a microcrystalline silicon (µc-Si) semiconductor material is used exhibits a good photoelectric conversion efficiency and is free of light-induced degradation [see, J. Meier et als., Mat. Res. Soc. Symp. Proc., vol. 420 pp. 3-14 1996 (hereinafter referred to as "document 1")]. In document 1, there are described that said photovoltaic element (solar cell) was prepared by a high frequency plasma CVD process wherein glow discharge is caused in an atmosphere composed of silane gas diluted with a large amount of hydrogen gas (H₂) by supplying a VHF (very high frequency) power with a frequency of 70 MHz therein and that the photovoltaic element is structured to have a p-i-n junction where the i-type semiconductor layer comprises a µc-Si semiconductor material. Document 1 describes that the photovoltaic element afforded a photoelectric conversion efficiency of 7.7 % and no light-induced degradation was observed for the photovoltaic element. Document 1 also describes that a stacked type photovoltaic element (solar cell) prepared by stacking a µc-Si semiconductor material and another µc-Si semiconductor material was found to have an initial photoelectric conversion efficiency of 13.1 % and a relative light-induced degradation of 12.4 %.

Besides, in K. Yamamoto et als., Jpn. J. Appl. Phys. vol. 33 (1994), pp. L1751-L1754, Part 2, No. 12B, 15 December 1994 (hereinafter referred to as "document 2"), there is described a photovoltaic element (a solar cell) having a polycrystalline layer formed by subjecting a heavily boron-doped a-Si (amorphous silicon) p-type layer to excimer laser annealing and a pillar-like µc-Si structure formed by way of plasma CVD on said polycrystalline layer.

However, the photovoltaic elements disclosed in documents 1 and 2 have such disadvantages as will be mentioned below.

Particularly, with reference to the description of document 1, it is understood that no light-induced degradation is observed for the microcrystalline photovoltaic elements disclosed therein. However, for the photovoltaic element for which no light-induced degradation was observed, it is understood that the µc-Si active layer is of a thickness of 3.6 µm which is relatively thick and that the short-circuit current of the photovoltaic element is 25.4 mA/cm² and the photoelectric conversion efficiency thereof is 7.7 % which is undesirably small. And it is also understood that in the formation of the µc-Si active layer with such large thickness of 3.6 µm, since the deposition rate is 1.2 Å/sec which is slow, it takes about 8 hours in order to complete the formation thereof. In addition, for the stacked type microcrystalline photovoltaic element disclosed in document 1, although the initial photoelectric conversion efficiency thereof is 13.1 % which is satisfactory, the photovoltaic element unavoidably suffers light-induced degradation upon repeated use where the initial photoelectric conversion efficiency is eventually deteriorated. And it obviously takes a long time for the preparation of the stacked type microcrystalline photovoltaic element.

With reference to the description of document 2, it is understood that the µc-Si active layer of the photovoltaic element is of a thickness of 2 µm, the short-circuit current of the photovoltaic element is 14.3 mA/cm², and the photoelectric conversion efficiency thereof is 2.5 % which is extremely small.

Separately, four persons of the group who reported document 2 jointly have developed the technique disclosed in document 2 and reported a thin film polycrystalline photovoltaic element (solar cell) formed by way of plasma CVD in which the active layer has a thickness of 3.5 µm and which has a short-circuit current of 26.12 mA/cm² and a photoelectric conversion efficiency of 9.8 % (see, Kenji Yamamoto et als., 14th European Photovoltaic Solar Energy Conference, Barcelona, Spain, 30 June-4 July 1997, pp,1018-1021). However, the photovoltaic element reported is still insufficient particularly in terms of the photoelectric conversion efficiency and the productivity.

### SUMMARY OF THE INVENTION

An principal object of the present invention is to eliminate the foregoing disadvantages in the prior art and to provide an improved microcrystalline series photovoltaic element which generates a large quantity of electric current and exhibits a high photoelectric conversion efficiency and a process for effectively producing said photovoltaic element.

Another object of the present invention is to provide an improved microcrystalline series photovoltaic element which exhibits a satisfactory photoelectric conversion efficiency even when the semiconductor layer is relatively thin and where the semiconductor layer can be formed at a high deposition rate, and which can be efficiently produced at low temperature and at a reasonable production cost, and a process for producing said photovoltaic element.

A further object of the present invention is to provide an improved microcrystalline series photovoltaic element which is stably exhibits excellent photovoltaic characteristics even when continuously used under sever environmental conditions over a long period of time, a process for producing said photovoltaic element, a building material in which said photovoltaic element is used, and a sunlight power generation apparatus in which said photovoltaic element is used.

A further object of the present invention is to provide, as aforesaid photovoltaic element, a microcrystalline series photovoltaic element having a stacked structure comprising a first semiconductor layer containing no crystalline phase therein, a second semiconductor layer containing approximately spherical microcrystalline phases, and a third semiconductor layer containing pillar microcrystalline phases which are stacked in this order, wherein the spherical microcrystalline phases of the second semiconductor layer on the side of the third semiconductor layer have an average size which is greater than that of those on the side of the first semiconductor layer and if necessary, the third semiconductor layer may have a layer region containing approximately spherical microcrystalline phases and pillar microcrystalline phases in a mixed state in the vicinity of the second semiconductor layer.

In the present invention, the term "microcrystalline phase" is meant a microcrystalline particle. The term "approximately spherical microcrystalline phase" is meant to a microcrystalline particle shaped in an approximately spherical form including a polyhedral spherical form or the like. The "size of the approximately spherical microcrystalline phase" is meant a diameter of said approximately spherical, microcrystalline particle. The term "pillar microcrystalline phase" is meant a microcrystalline particle shaped in a pillar form.

### BRIEF DESCRIPTION OF THE DRAWINGS

FIG. 1 is a schematic cross-sectional view illustrating an example of a photovoltaic element according to the present invention.
FIG. 2 is a schematically enlarged view of a portion A in FIG. 1.
FIG. 3 is a schematically enlarged view of a portion B in FIG. 2.
FIG. 4 is a schematic block diagram illustrating an example of a sunlight power generation apparatus according to the present invention.
FIG. 5 is a schematic diagram illustrating an example of a film-forming apparatus suitable for forming a semiconductor layer in the present invention.

### DESCRITION OF THE INVENTION AND PREFERRED EMBODIMENTS

The present invention eliminates the foregoing disadvantages found in the prior art and attains the above described objects.

As previously described, a first aspect of the present invention is to provide a microcrystalline series photovoltaic element which is stably exhibits excellent photovoltaic characteristics even when continuously used under sever environmental conditions over a long period of time.

The photovoltaic element provided according to the present invention typically has a stacked structure comprising a first semiconductor layer containing no crystalline phase, a second semiconductor layer containing approximately spherical microcrystalline phases, and a third semiconductor layer containing pillar microcrystalline phases which are stacked in this order, wherein said spherical microcrystalline phases of said second semiconductor layer on the side of said third semiconductor layer have an average size which is greater than that of said spherical microcrystalline phases of said second semiconductor layer on the side of said first semiconductor layer. If necessary, it is possible for the third semiconductor layer to have a layer region containing approximately spherical microcrystalline phases and pillar microcrystalline phases in a mixed state in the vicinity of the second semiconductor layer.

Any of the semiconductor layer containing no crystalline phase and the semiconductor layer containing microcrystalline phases may principally comprises a hydrogen-containing silicon (Si) material, a hydrogen-containing silicon-germanium (Si-Ge) material, a hydrogen-containing silicon carbide (SiC) material, or a mixture of these.

A second aspect of the present invention is to provide a process for producing said photovoltaic element. The process typically comprises the steps of: (a) forming a first semiconductor layer which contains no crystalline phase but contains a desired amount of a doping element on a substrate, (b) forming a second semiconductor layer which contains no crystalline phase and contains no doping element or a trace amount of a doping element on said first semiconductor layer to obtain a layered product, (c) laser-annealing said layered product from the second semiconductor layer side by way of irradiation of laser beam to microcrystallize only the second semiconductor layer so as to contain approximately spherical microcrystalline phases such that said spherical microcrystalline phases situated on the laser-irradiated side have an average size which is greater than that of said spherical microcrystalline phases situated on the first semiconductor layer side, and (d) forming a third semiconductor layer containing pillar microcrystalline phases on said microcrystallized second semiconductor layer.

In the above process, the method of forming the microcrystallized second semiconductor layer by means of the laser-annealing may be replaced by a method wherein the second semiconductor layer is formed by way of plasma CVD using a given raw material gas while diluting said raw material gas with hydrogen gas (H₂), and in the course of forming the second semiconductor layer, the dilution ratio of the raw material gas with the hydrogen gas is increased, whereby the second semiconductor layer is formed to contain approximately spherical, microcrystalline phases such that said spherical microcrystalline phases situated on the third semiconductor layer side has an average size which is greater than that of said spherical microcrystalline phases situated on the first semiconductor layer side.

Besides, the method of forming the microcrystallized second semiconductor layer by means of the laser-annealing may be replaced by a method wherein the second semiconductor layer is formed by way of plasma CVD using a given raw material gas while diluting said raw material gas with hydrogen gas (H₂), and in the course of forming the second semiconductor layer, the substrate temperature is increased, whereby the second semiconductor layer is formed to contain approximately spherical microcrystalline phases such that said spherical microcrystalline phases situated on the third semiconductor layer side has an average size which is greater than that of said spherical microcrystalline phases situated on the first semiconductor layer side.

A third aspect of the present invention is to provide a building material comprising aforesaid photovoltaic element integrally sealed by a sealing material including a back face reinforcing material.

A fourth aspect of the present invention is to provide a sunlight power generation apparatus comprising aforesaid photovoltaic element and a power converting means for converting a power generated by said photovoltaic element into a prescribed power.

In the following, the present invention will be described in more detail with reference to the drawings.

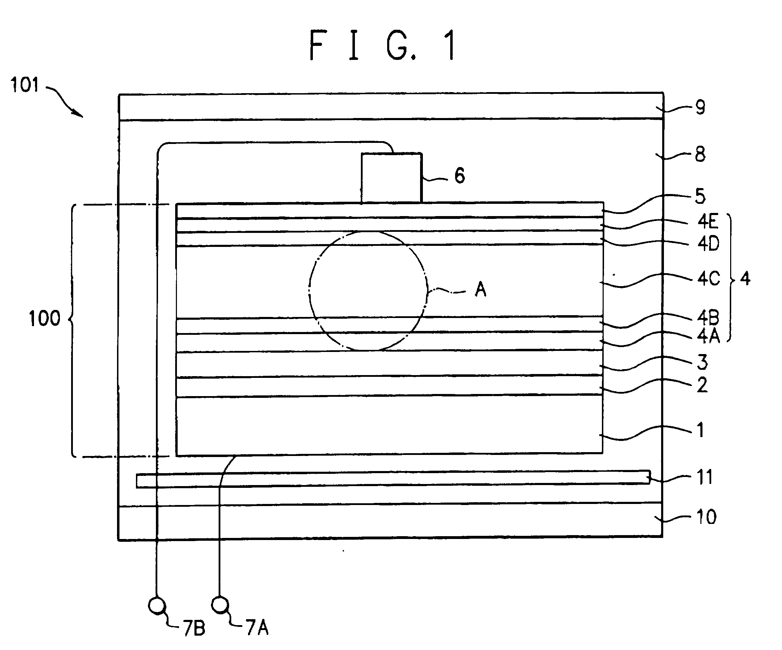

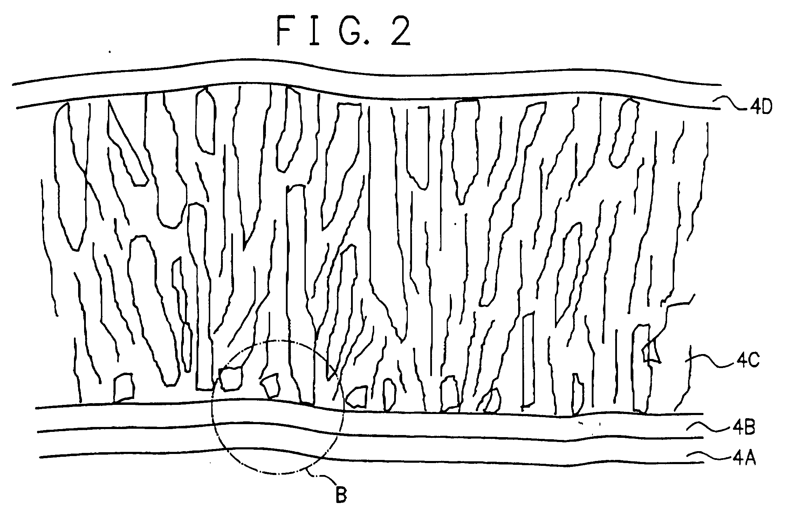

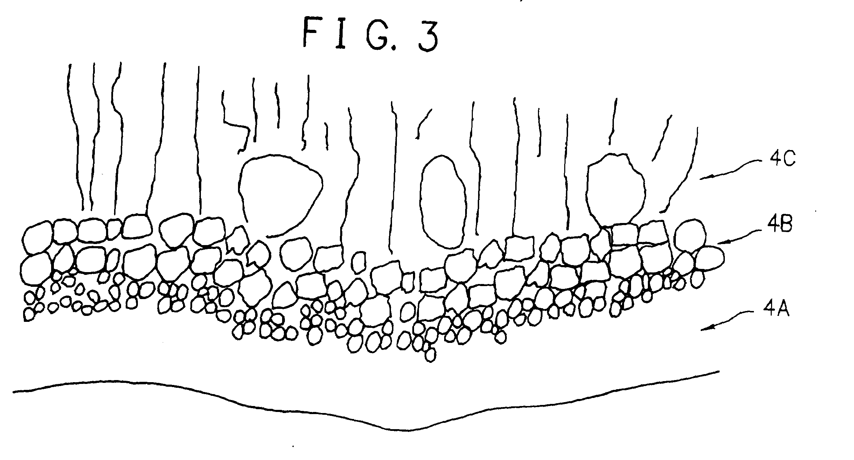

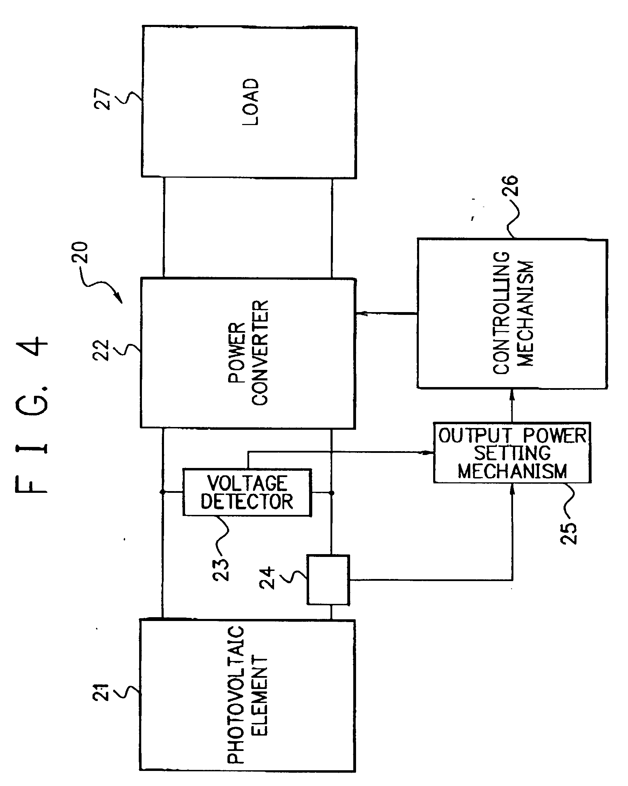

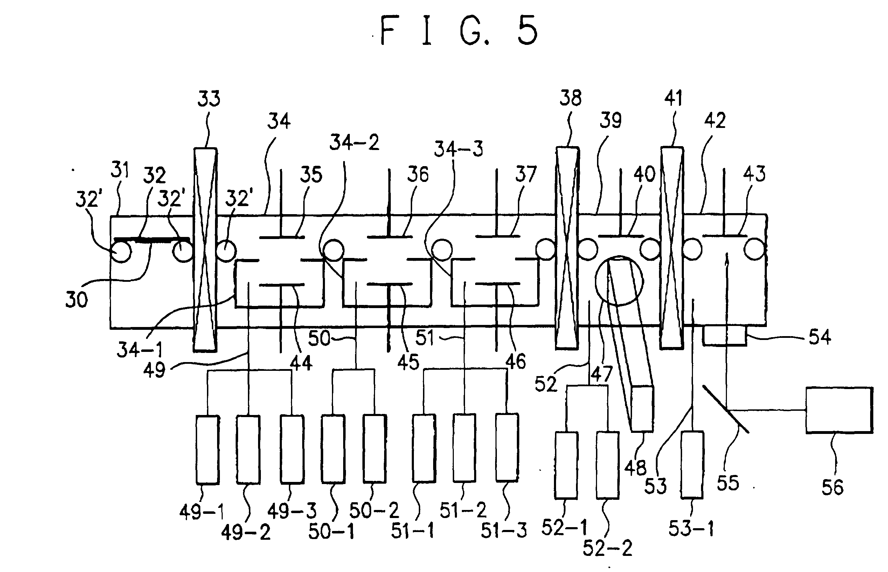

FIG. 1 is a schematic cross-sectional view illustrating an example of a photovoltaic element according to the present invention. FIG. 2 is a schematically enlarged view of a portion A in FIG. 1 based on an observed cross-section image obtained by means of a transmission electron microscope. FIG. 3 is a schematically enlarged view of a portion B in FIG. 2 based on an observed cross-section image obtained by means of a transmission electron microscope. FIG. 4 is a schematic block diagram illustrating an example of a sunlight power generation apparatus according to the present invention. FIG. 5 is a schematic diagram illustrating on example of a film-forming apparatus suitable for forming a semiconductor layer In the present invention.

Now, in FIG. 1, there is shown a photovoltaic element 100 (or a solar cell) which is sealed into a photovoltaic element module 101 (or a solar cell module) so as to be capable of being used, for instance, as a power generation source. It should be understood that this module is only an embodiment when the photovoltaic element of the present invention is practically used as a power generation source and is not limitative. The photovoltaic element of the present invention may be modularized into other appropriate forms depending upon application purposes. And in FIG. 1, there is shown only one photovoltaic element for simplification purposes. The photovoltaic element 100 in FIG. 1 may comprise a desired number of photovoltaic elements having the same constitution as the photovoltaic element 100 which are electrically connected with each other in series connection or parallel connection so as to obtain a prescribed voltage and electric current.

First, description will be made of the photovoltaic element 100 with reference to FIGs. 1 to 3.

The photovoltaic element 100 comprises a back reflecting layer 2, a transparent electrically conductive layer 3, and a semiconductor layer 4 having a semiconductor junction (this layer will be hereinafter referred to as "semiconductor junction layer") stacked in this order on a substrate 1, where a combination of the substrate, the back reflecting layer 2 and the transparent electrically conductive layer 3 serves as a lower electrode.

Reference numeral 5 indicates a transparent upper electrode layer which is formed on the semiconductor junction layer 4, and reference numeral 6 indicates a collecting electrode (or a grid electrode) which is formed on the upper electrode layer 5.

In the following, description will be made of each constituent of the photovoltaic element 100.

### Substrate

As the substrate 1, there can be used metal members, alloy members, composites of these members, carbon sheets, and synthetic resin films. These members can be used in a roll form and therefore, are suitable for continuous production of a photovoltaic element. Besides these members, crystalline substrates such as a silicon wafer, substrates made of glass, and substrates made of ceramics may be used depending upon use purpose of a photovoltaic element produced.

When a transparent member such as a glass plate is used as the substrate 1, it is possible that light is impinged from the side of the substrate 1.

In the case where a magnetic member such as a member made of stainless steel such as SUS 430 stainless steel is used as the substrate 1, for instance, in the process of forming a semiconductor layer, the substrate 1 can be transported while precisely controlling the position of the substrate by means of a roller provided with a magnet therein.

The substrate 1 comprising any of the foregoing members can be used as it is. However, it is possible to grind the surface of the substrate on which a film is to be formed.

Separately, it is possible to use a member having a surface provided with irregularities such as a dull-finished stainless steel member obtained, by way of rolling using rollers as the substrate 1. It is also possible to use a steel member whose surface being provided with irregularities obtain by subjecting an iron steel to a surface treatment with nickel or aluminum as the substrate 1.

In the case where the substrate 1 is electrically conductive, it is possible to make the substrate to serve as one of the electrodes for outputting a power from the semiconductor junction.

### Back Reflecting Layer

The back reflecting layer 2 is used for reflecting light passed through the semiconductor junction layer 4 to reach thereto toward the semiconductor junction layer.

In the case where the surface of the substrate 1 has a high reflectance, the back reflecting layer 2 may be omitted.

In the case where the substrate 1 is insulative, it is possible to make the back reflecting layer 2 such that it also serves as an electrode layer.

In the case where the substrate 1 comprises a stainless steel member or a carbon member, it is preferred to form a metallic film of Al, Ag or Cu-Mg alloy on the surface of such member by way of sputtering or the like, as the back reflecting layer 2. In this case, it is possible to make said metallic film as the back reflecting layer 2 to have a surface provided with irregularities by forming said metallic film at a relatively large thickness under film-forming conditions of a relatively high film-forming temperature (a relatively high substrate temperature) and a relatively low deposition rate. Alternatively, it is possible that said metallic film as the back reflecting layer 2 is formed by way of sputtering and thereafter, the metallic film is subjected to a surface etching treatment to form irregularities at the surface of the metallic film.

Separately, in the case where light is impinged from the side of the substrate 1, it is preferred that the back reflecting layer 2 is provided on the surface side of the semiconductor junction layer 4 (that is, the non-light receiving side in this case).

### Transparent Electrically Conductive Layer

The transparent electrically conductive layer 3 is used for transmitting light reflected by the back reflecting layer 2 into the semiconductor junction layer 4. By the presence of the transparent electrically conductive layer 3, the light absorption efficiency in the semiconductor junction layer 4 is increased. However, the transparent electrically conductive layer 3 is not always necessary to be provided.

The transparent electrically conductive layer 3 may be formed by a conventional film-forming method such as sputtering, vacuum evaporation, CVD (chemical vapor phase deposition), ion plating, ion beam deposition, or ion beam sputtering. Besides, the transparent electrically conductive layer 3 may be formed by means of an electro-deposition method using an aqueous solution containing nitric acid radical, acetic acid radial or ammonium radical, and metal ions, or a dipping method.

The transparent electrically conductive layer 3 is desired to be highly transparent because it serves to transmit light passed through the semiconductor junction layer 4 until the back reflecting layer 2. In addition, the transparent electrically conductive layer 3 is desired to have an appropriate resistance in order to restrain an electric current flown through a defect of the semiconductor junction layer 4. Further in addition, the transparent electrically conductive layer 3 is desired to have a function to prevent the constituent elements of the back reflecting layer 2 from being dispersed into the semiconductor junction layer 4.

The transparent electrically conductive layer 3 is desired to be constituted by a metal oxide material such as zinc oxide (ZnO), indium oxide (In₂O₃), tin oxide (SnO₂), ITO (In₂O₃-SnO₂), titanium oxide (TiO₂), or a mixture of these.

It is possible for the transparent electrically conductive layer 3 to be formed so as to have a surface provided with irregularities having an average top-to-valley elevation of about 100 nm by controlling the conditions upon forming the transparent electrically conductive layer.

Alternatively, the transparent electrically conductive layer having such uneven surface may be formed by a method wherein a given transparent electrically conductive layer having a flat surface is formed and the layer is subjected to a surface etching treatment by way of wet etching using an aqueous solution of acetic acid or the like.

In the case where a given transparent electrically conductive layer as the transparent electrically conductive layer 3 is formed by means of sputtering, it is possible to make said layer to have a surface provided with irregularities having a large average top-to-valley elevation by forming said layer at a relatively large thickness under film-forming conditions of a relatively high substrate temperature and a relatively low deposition rate. In the case where a given transparent electrically conductive layer as the transparent electrically conductive layer 3 is formed by means of an electro-deposition method using such aqueous solution as above described, it is possible to make said layer to have a surface provided with irregularities having a large average top-to-valley elevation by forming said layer under conditions of increasing the metal ion concentration of the aqueous solution and increasing the thickness of the layer formed.

### Semiconductor Junction Layer

The semiconductor junction layer 4 functions to convert incident light into electricity.

For a layered microcrystalline series semiconductor junction structure, the present inventors obtained a finding through experimental studies that the characteristics of the active semiconductor layer in which carriers are generated based on incident light are affected by its conformity with the backing semiconductor layer. In order to overcome this shortcoming, the present inventors conducted experimental studies. As a result, there was obtained a finding that when (a) a semiconductor layer containing no crystalline phase is used as the backing semiconductor layer and (b) a semiconductor layer containing pillar microcrystalline phases is need as the active semiconductor layer where said semiconductor layer (b) is stacked on said semiconductor layer (a), and the boundary region between the two semiconductor layers (a) and (b) is structured to comprise a semiconductor material containing approximately spherical microcrystalline phases having a varied average size distribution such that said spherical microcrystalline phases on the side of said semiconductor layer (b) have an average size which is greater than that of said spherical microcrystalline phases on the side of the semiconductor layer (a), there can be attained a desirable stacked semiconductor junction which is free of such shortcoming as above described and has improved characteristics. The present invention has been accomplished on the basis of this finding.

As a preferable embodiment of the semiconductor junction layer 4 in the present invention, there can be mentioned a semiconductor junction structure comprising a first semiconductor layer 4A, a second semiconductor layer 4B, a third semiconductor layer 4C, a fourth semiconductor layer 4D, and a fifth semiconductor layer 4E stacked in this order as shown in FIGs. 1 to 3.

The semiconductor junction layer 4 in the present invention may be formed by means of a plasma CVD method using, for instance, a plasma CVD apparatus in which a high frequency power of from a radio frequency of 13.56 MHz to a microwave of 2 GHz can be used. Besides, the semiconductor junction layer 4 may be formed by way of a combination a plasma CVD method, an ECR plasma CVD method, or a sputtering method and a film-forming manner using an active hydrogen gas.

Specifically, the semiconductor layers 4A-4E may be separately formed in different film-forming chambers of a film-forming apparatus as shown in FIG. 5. Alternatively, they may be formed in a common film-forming chamber by changing the film-forming conditions upon forming each semiconductor layer.

It is also possible for these semiconductor layers to be continuously formed using a roll-to-roll film-forming apparatus.

In any case, in the formation of the semiconductor junction layer 4, its constituent semiconductor layers are desired to be formed without exposing these semiconductor layers to atmospheric air in the course of their formation.

In the case of forming the semiconductor junction layer 4 by means of a plasma CVD methods SiH₄, SiF₄, Si₂H₆, GeH₄, CH₄, C₂H₆ and the like may be selectively used as the raw material gas. These raw material gases are used by diluting with an appropriate dilution gas. Such dilution gas, H₂ gas, He gas, Ar gas, and the like may be selectively used. In order to form an n-type or p-type semiconductor layer, an appropriate gaseous doping material capable of imparting a given doping element is used together with a given raw material gas. Such gaseous doping material can include, for example, PH₃, BH₃, BF₃, and the like.

The junction structure of the semiconductor junction layer 4 typically may be a n-i-p structure or a p-i-n structure.

The junction structure is not limited to these semiconductor junction structures, and it may take other semiconductor junction structures. Specifically, the junction structure may be a n⁺-n⁻-p⁺ structure, a n⁺-p⁻-p⁺ structure, a p⁺-p⁻-n⁺ structure, or a p⁺-n⁻-n⁺ structure.

Besides, it is also possible for the junction structure to be structured such that the conduction type is graded in the thickness direction.

In the formation of a semiconductor layer of n- or p-type, it is preferred to supply a prescribed amount of a gaseous doping material capable of imparting a given doping element in an amount of 0.1 to 10 atomic % versus the atomic number of silicon (Si) atoms, germanium (Ge) atoms or carbon (C) atoms as the main constituent of the semiconductor layer. In the case of slightly doping a substantially intrinsic semiconductor layer, it is preferred to supply a prescribed amount of a gaseous doping material capable of imparting a given doping element in an amount of 0.1 to 10 ppm. It is a matter of course that any gaseous doping material is not necessitated to be used in the formation of an intrinsic semiconductor layer.

The semiconductor junction layer 4 may contains hydrogen atoms in an amount of 1 to 20 atomic %. Incidentally, even when the semiconductor junction layer 4 should contain a trace amount of one or more kinds of atoms selected from a group consisting of oxygen atoms, nitrogen atoms, and fluorine atoms, the principle of the present invention is not hindered.

In the present invention, it is possible that two or more of semiconductor junction layers having the same structure as the semiconductor junction layer 4 are present in the photovoltaic element.

The first semiconductor layer 4A comprises a semiconductor material containing no crystalline phase. The first semiconductor layer 4A is preferred to contain a doping element. For the thickness of the first semiconductor layer 4A, it is preferred to be in a range of from 0.5 to 50 nm.

In the observation by means of a transmission electron microscope, the first semiconductor layer 4A is observed to have an uniform texture without any particle structure with a magnitude of about 5 nm or more.

The second semiconductor layer 4B comprises a semiconductor material containing approximately spherical microcrystalline phases. The second semiconductor layer 4B may be formed by a method of forming a given semiconductor layer containing no crystalline phase by means of a plasma CVD method, and microcrystallizing said semiconductor layer by way of laser-annealing or the like. In the case where the second semiconductor layer 4B is formed by way of laser-annealing in this way, said semiconductor which is subjected to laser-annealing is preferred to contain substantially no doping element in view of making it possible to desirably microcrystallize only the semiconductor layer which becomes the second semiconductor layer 4B. In this case, when the intensity of laser beam used in the laser-annealing is excessively strong or weak, desired microcrystallization of the semiconductor layer does not take place.

When the intensity of said laser beam is made to be in a range of from 100 to 250 mJ/cm², there can be obtained a desirably microcrystallized semiconductor layer suitable as the second semiconductor layer 4B.

Alternatively, the second semiconductor layer 4B may be formed by a method wherein upon forming a given semiconductor layer as the second semiconductor layer 4B by means of a plasma CVD method, related film-forming conditions including the inner pressure in the film-forming chamber, the wattage of a high frequency power supplied, the flow rate of a raw material gas introduced, the flow rate of a gaseous doping material introduced, the substrate temperature, and the dilution ratio of said raw material gas by hydrogen gas are periodically changed, whereby said semiconductor layer is formed to contain approximately spherical microcrystalline phases having a varied average size distribution in the thickness direction. In this case, particularly by periodically changing the substrate temperature and the dilution ratio of the raw material gas by hydrogen gas, there can be formed approximately spherical microcrystalline phases having a varied average size distribution in the thickness direction.

For the thickness of the second semiconductor layer 4B, it is preferred to be in a range of from 5 to 60 nm.

In the observation by means of a transmission electron microscope, the second semiconductor layer 4B is observed to have approximately spherical microcrystalline phases with an average size in a range of from about 1 to about 10 nm on the side of the first semiconductor layer 4A and have approximately spherical microcrystalline phases with an average size in a range of from about 5 to about 20 nm on the side of the third semiconductor layer 4C. The approximately spherical microcrystalline phases in either side are not necessary to be uniform with respect to their magnitude.

As previously described, the term "microcrystalline phase" is meant a microcrystalline particle. The term "approximately spherical microcrystalline phase" is meant to a microcrystalline particle shaped in an approximately spherical form including a polyhedral spherical form or the like. The "size of the approximately spherical microcrystalline phase" is meant a diameter of said approximately spherical microcrystalline particle.

The third semiconductor layer 4C comprises a semiconductor material containing pillar microcrystalline phases. For the thickness of the third semiconductor layer 4C, it is preferred to be in a range of from 500 to 5000 nm.

In the observation by means of a transmission electron microscope, the third semiconductor layer 4C is observed to have (a) pillar microcrystalline phases having a relatively long length in the thickness direction and (b) pillar microcrystalline phases having a relatively short length in the thickness direction in a mixed state. The pillar microcrystalline phase (a) has a length nearly the same as the thickness of the third semiconductor layer 4C and a width of less than 500 nm in a direction perpendicular to the thickness direction.

The third semiconductor layer 4C may have a region additionally containing approximately spherical microcrystalline phases having an average size of about 10 to about 50 nm mingled therein in the vicinity of the second semiconductor layer 4B. In this case, the spherical microcrystalline phases mingled account for a proportion of 10 to 80 % in a plane in parallel to the second semiconductor layer 4B.

The fourth semiconductor layer 4D comprises a buffer layer which serves to provide an improved joining state between the third semiconductor layer 4C and the fifth semiconductor layer 4E. The fourth semiconductor layer 4D is not always necessary to be provided. The buffer layer as the fourth semiconductor layer 4D is preferred to comprise a semiconductor material containing no crystalline phase and no doping element. For the thickness thereof, it is preferred to be in a range of from 0.5 to 50 nm.

The fifth semiconductor layer 4E is preferred to comprise a semiconductor material containing a prescribed doping element and containing crystalline phases capable of providing an effect of improving light transmittance. For the thickness of the fifth semiconductor layer 4E, it is preferred to be in a range of from 0.1 to 20 nm.

Each of the fourth semiconductor layer 4D and the fifth semiconductor layer 4E is preferred to be formed at a substrate temperature which is lower than that upon forming each of the first to third semiconductor layers 4A-4C. In the case where the fourth semiconductor layer 4D and the fifth semiconductor layer 4E are formed respectively at a relatively high substrate temperature, they do not have characteristics required for them. The reason for this is considered such that occurrence of diffusion of the dopant and occurrence of release of hydrogen atoms compensating dangling bonds in the semiconductor layer would be chiefly contributed.

As above described, the semiconductor junction layer 4 has a stacked structure comprising the first semiconductor layer 4A containing no crystalline phase, the second semiconductor layer 4B containing such approximately spherical microcrystalline phases as above described, and the third semiconductor layer 4C containing such pillar microcrystalline phases as above described which are stacked in this order. And as shown in FIG. 3, the approximately spherical microcrystalline phases are contained in the second semiconductor layer 4B such that part of them situated on the side of the third semiconductor layer 4C have an average size which is greater than that of those situated on the side of the first semiconductor layer 4A. And the third semiconductor layer 4C may have a region containing approximately spherical microcrystalline phases mingled together with the pillar microcrystalline phases in the vicinity of the second semiconductor layer 4B.

In the semiconductor junction layer 4 thus structured, it is considered that the approximately spherical microcrystalline phases having a relatively small average size of the second semiconductor layer 4B function to establish an improved junction between the second semiconductor layer 4B and the first semiconductor layer 4A containing no crystalline phase and the pillar microcrystalline phases of the third semiconductor layer 4C are grown from the approximately spherical microcrystalline phases having a relatively large average size of the second semiconductor layer 4B so as to establish an improved junction between the second semiconductor layer 4B and the third semiconductor layer 4C. This situation in the semiconductor junction layer 4 is considered to provide such effects as will be described in the following. That is, the proportion for carriers, which are generated based on incident light, to be extinguished at the junction interface is decreased, and the proportion of an electric current to be outputted to the outside is increased. In addition, the stress and distortion which will be occurred due to a structural difference are relaxed.

In accordance with the foregoing structure of the junction semiconductor layer 4, even when the third semiconductor layer 4C is formed to be relatively thin at a high deposition rate, a large quantity of electric current is generated in the junction semiconductor layer 4.

### Transparent Upper Electrode Layer

The transparent upper electrode layer 5 is formed on the semiconductor junction layer 4. The electrode layer 5 functions to take up a power generated in the semiconductor junction layer 4. The electrode layer 5 is situated to oppose the substrate 1 side through which a power generated in the semiconductor junction layer is also outputted.

The electrode layer 5 is desired to be constituted by a material having a low resistance. Such material can include, for example, zinc oxide (ZnO), indium oxide (In₂O₃), tin oxide (SnO₂), ITO (In₂O₃-SnO₂), titanium oxide (TiO₂), or a mixture of these.

The electrode layer 5 may be formed by means of resistance heating evaporation, ion beam deposition, vacuum evaporation, sputtering, CVD (chemical vapor phase deposition), spraying, and dipping.

In the case where light is impinged from the side of the electrode layer 5, in order for the electrode layer 5 to provide a good reflection preventive effect for incident light, it is preferred that the electrode layer 5 is made to have a thickness corresponding to a value obtained by dividing the wavelength of light mainly intended to be prevented from being reflected by a value corresponding to 4 times the refractive index of the electrode layer 5. Specifically, for instance, supposing that the refractive index of the electrode layer 5 is 2 and the wavelength of light which is most intended to pass through the electrode layer is 500 nm, a value of about 63 nm which is calculated from the equation 500/(2 x 4) is a preferred thickness for the electrode layer 5.

The electrode layer 5 may be a layered material comprising a plurality of materials having a different refractive index.

In the above, description has been made of the photovoltaic element having an integrated structure comprising the lower electrode, the semiconductor junction layer 4 and the upper electrode layer 5 as an embodiment of a photovoltaic element according to the present invention. The present invention is not limited such structure.

### Collecting Electrode

It is possible that a collecting electrode 6 in a grid form is provided on the upper electrode layer 5 in order to efficiently collect the electric current generated by virtue of a photoelectromotive force on the upper electrode layer 5.

The collecting electrode 6 may be formed by means of sputtering, resistance heating evaporation, or CVD, using a mask pattern. Besides, the collecting electrode 6 may be also formed by a method of firstly forming a metallic film over the entire surface of the upper electrode layer 5 and patterning the metallic film by way of etching to remove unnecessary portions thereof, a method of directly forming a grid electrode pattern on the surface of the upper electrode layer 5 by way of photo CVD, a method of firstly forming a negative patterning mask having a grid electrode pattern on the surface of the upper electrode 5 and performing plating thereon, a method of screen-printing an electrically conductive paste to form a grid electrode pattern on the surface of the upper electrode 5, or a method of a copper wire applied with a carbon paste thereon is bonded on tile surface of the upper electrode 5 by way of thermocompression bonding to form a grid electrode.

If necessary, in order to output an electromotive force, it is possible that a power output terminal 7A is electrically connected to the substrate 1 and a power output terminal 7A is electrically connected to the collecting electrode 6 as shown in FIG. 1.

Description will be made of the photovoltaic element module 101.

The photovoltaic element module 101 specifically comprises a body comprising tile photovoltaic element 100 structured as above described which is encapsulated by a sealing material 8, a surface protective film 9 laminated on the light receiving side of said body and a back face reinforcing member 10 which is laminated on the non-light receiving side of said body. Reference numeral 11 indicates an insulating member which is provided between the substrate 1 of the photovoltaic element 100 and the back face reinforcing member 10.

In the following, description will be made of each constituent of the photovoltaic element module, except for the photovoltaic element for which description already has been made in the above.

### Sealing Material

The sealing material 8 is used to seal the photovoltaic element 100 in order to protect the photovoltaic element from surrounding environments such as temperature changes, moisture, external shock, and the like. The sealing material 8 also serves to ensure the adhesion of the body comprising the sealing material 8 in which the photovoltaic element 100 is enclosed with the surface protective film 9 and also the adhesion of said body with the back face reinforcing member 10.

The sealing material 8 is desired to comprise a resin which has adhesion properties and filling properties and excels particularly in weatherability, heat resistance, cold resistance, and shock resistance. Specific preferable examples of such resin are polyolefin series resins, urethane resins, silicone resins, and fluororesins.

The sealing material 8 may contain a cross-liking agent comprising an organic peroxide. In this case, in vacuum lamination treatment for the production of the photovoltaic element module, thermocompression bonding of the sealing material can be performed while the sealing material being crosslinked. Besides, the sealing material 8 may also contain one or more materials selected from a group Consisting of a crosslinking assistant, an UV absorber, a photo stabilizer, an antioxidant, a silane coupling agent, and an organic titanate compound in order to improve the properties of the sealing material.

In any case, the sealing material 8 is required to be transparent in order to prevent the quantity of incident light to reach the semiconductor junction layer 4 of the photovoltaic element 100 from being diminished as much as possible. In view of this, the sealing material 8 is desired to have a light transmittance of preferably more than 80 % or more preferably more than 90 % with respect to visible light having a wavelength of 400 to 800 nm.

Further, the sealing material 8 is desired to have a refractive index preferably in a range of from 1.1 to 2.0 or more preferably in a range of from 1.1 to 1.6 at 25 °C in order to facilitate the incidence of light from atmospheric air.

### Surface Protective Film

The surface protective film 9 is positioned at the outermost surface of the photovoltaic element module 101 and because of this, it is required to excel in transparency, weatherablity, water repellency, heat resistance, pollution resistance, and physical strength. The surface protective film 9 is desired to comprise a resin film which satisfies these requirements. Specific preferable examples of such resin film are fluororesin films, and acrylic resin films.

The face of the surface protective film 9 which is contacted with the sealing material 8 is desired to be applied with a surface treatment by way of corona treatment, plasma treatment, ozone treatment, UV irradiation treatment, electron beam irradiation treatment, or flame treatment, in order to improve the adhesion of the surface protective film 9 with the sealing material 8.

Not only the surface protective film 9 but also the sealing material 8 may have irregularities at their surface. Such irregularities may be formed during the vacuum lamination treatment for the production of the photovoltaic element module or may be formed after the vacuum lamination treatment by way of press working.

### Back Face Reinforcing Member

The back face reinforcing member 10 is disposed at the back face of the photovoltaic element module 101 for the purposes of improving the mechanical strength of the photovoltaic element module and preventing the photovoltaic element module from being distorted or warped due to a change in the environmental temperature.

The back face reinforcing member 10 may comprise a nylon sheet, a PET (polyethylene terephthalate) sheet, a steel plate, a plastic plate, or a fiberglass reinforced plastic plate (or so-called FRP plate).

In the case where the back face reinforcing member 10 comprises a member having a large mechanical strength, the photovoltaic element module 101 can be used as a building material such as a roofing material. In this case, the photovoltaic element module can be designed into a building material integral type photovoltaic element module (or a building material integral type solar cell module).

### Insulating Member

In the case where the back face reinforcing member 10 is electrically conductive, in order to ensure electrical isolation of the substrate 1 of the photovoltaic element 100 from the back face reinforcing member 10, the insulating member 11 is provided between the substrate 1 and the back face reinforcing member 10. The insulating member may comprise an insulating film such as a nylon film or the like.

In the following, description will be made of an embodiment of a power generation apparatus according to the present invention while referring to FIG. 4.

A power generation apparatus 20 shown in FIG. 4 is for supplying a power to a load 27, and it is provided with a photovoltaic element 21, a power converter 22, a voltage detector 23, an electric current detector 24, an output power setting mechanism 25, and a controlling mechanism 26.

In the power generation apparatus 20, a D.C. power generated by the photovoltaic element 21 is inputted into the power converter 22 where the D.C. power is converted into an adequate power, followed by supplying to the load 27.

The output voltage and output electric current of the photovoltaic element 21 are detected respectively by the voltage detector 23 and the electric current detector 24, signals detected by these detectors 23 and 24 are inputted into the output power setting mechanism 25 where said signals are processes, and the controlling mechanism 26 controls the power converter 22 based on a signal transmitted thereto from the output power setting mechanism 25.

As the photovoltaic element 21, the foregoing photovoltaic element module 101 can be used. In this case, it is desired for the photovoltaic element 100 of the photovoltaic element module 101 to comprise a plurality of photovoltaic elements each structured in the same way as the photovoltaic element 100 which are electrically connected so as to obtain desired voltage and electric current.

The power converter 22 may comprise a DC/DC converter using a self-turning off type switching element such as a power transistor, a power FET, or an IGBT, or a self-commutated DC/AC inverter. The power converter 22 controls power tidal current, input and output voltage, output frequency, and the like based on the ON/OFF duty ratio (so-called conduction ratio) and the frequency of a gate pulse transmitted from the controlling mechanism 26.

As the load 27, there are various things including electric heating loads, electric motor lords, and the like.

In the case where the power supplied is an A.C. power, the load 27 may be a commercial A.C. power supply system. In the case where the power supplied is an D.C. power, the load 27 may be a rechargeable battery. In this case, it is desired that the capacity of the rechargeable battery is sufficiently increased and supervision of the rechargeable battery in a charged state is conducted. In the case where the power supplied is an D.C. power, the power converter 22 comprises the foregoing DC/DC converter.

In the voltage detector 23, for instance, the output voltage of the photovoltaic element 21 is divided by means of a resistor, followed by being A/D-converted into a digital value, which is transmitted into the output power setting mechanism 25. In this case, in order to avoid invasion of a noise, it is desired that an power output circuit (not shown) of the photovoltaic element 21 and a transmitting circuit (not shown) for a signal detected by the voltage detector are insulated by a photocoupler or the like capable of performing complete insulation between input and output.

In the electric current detector 24, for instance, the output electric current of the photovoltaic element 21 is converted into a voltage by means of a Hall element or a standard resistor, followed by making it into a digital value in the same manner as in the voltage detector 23, which is transmitted into the output power setting mechanism 25.

In each of the voltage detector 23 and the electric current detector 24, it is desired to use a sufficiently high speed and highly precise A/D converter. Specifically, it is desired to use an A/D converter having a resolution of more than 10 bits and a sampling speed of more than 50 kHz. According such A/D converter, it is possible to establish a control system whose error is less than 0.1 % and which provides a response within less than 1 second.

The output power setting mechanism 25 perform calculation based on detected signals transmitted from the voltage detector 23 and the electric current detector 24 to decide a set value for output voltage whereby controlling the conduction ratio and the like of the gate circuit so that the photovoltaic element 21 has a set value for the output voltage thereof. The output power setting mechanism 25 is concretized as a controlling microcomputer, and it is provided with a CPU, a RAM, a ROM, an input-output port, a numerical computing unit and the like.

The controlling mechanism 26, comprises a so-called gate driving circuit which generates a gate pulse by way Of comparison of momentary current values, a comparison equation of sine wave/chopping wave, or the like. Based on the gate pulse generated by the controlling mechanism 26, the power converter 22 is controlled so that the output voltage of the photovoltaic element 21 is in agreement with the output of the output power setting mechanism 25. The controlling mechanism 26 may comprise an analog circuit or a digital circuit. Besides, the controlling mechanism 26 may comprise a digitalized mechanism provided with a CPU or a DSP (digital signal processor) as a high speed CPU. In this case, the constitution of the controlling mechanism 26 is similar to that of the output power setting mechanism 25. In this connection, it is possible to use an adequate circuit which functions as both the output power setting mechanism 25 and the controlling mechanism 26.

In the following, the present invention will be described in more detail with reference examples. It should be understood that these examples are only for illustration purposes and not intended to restrict the scope of the present invention to these examples.

### Example 1

In this example, a plurality of photovoltaic elements having such constitution of the photovoltaic element 100 shown in FIGs. 1 to 3 were prepared while conducting evaluation depending upon necessity, and using these photovoltaic elements, a plurality of photovoltaic element modules having such constitution of the photovoltaic element module 101 shown in FIG. 1.

### 1. Preparation of Photovoltaic Element:

Bach photovoltaic element was prepared in the following manner.

As the substrate 1, there were provided a plurality of dull-finished stainless steel SUS 430 plates having an uneven surface end having a square form of 45 mm x 45 mm and a thickness of 0.15 mm. These stainless steel plates as the substrate 1 were subjected to alkali-washing. hot-water washing, and air-dried. The stainless steel plates thus cleaned were arranged in a deposition chamber of a D.C. magnetron sputtering apparatus, where the inside of the deposition chamber was evacuated until the inner pressure became less than 2 mTorr. Thereafter, Ar gas was introduced into the deposition chamber of the sputtering apparatus at a flow rate of 30 sccm, and the inner pressure of the deposition chamber was maintained at 2 mTorr. Thereafter, each of the substrates 1 (that is, the stainless steel plates) was heated to and maintained at 400 °C, and a D.C. power of 1 Kw was applied to an Ag target of 6 inches (15.24 cm) in diameter for 90 seconds to form an about 600 nm thick Ag-layer as the back reflecting layer 2 on the uneven surface of each substrate 1. At this time, one of the substrates 1 each having the Ag-layer as the back reflecting layer 2 formed thereon was taken out from the sputtering apparatus and it was observed by means of a scanning electron microscope with respect to its surface state. As a result, it was found to have an uneven surface provided with irregularities having an average top-to-valley elevation of about 100 nm. Thereafter, the electrical connection to the Ag-target was switched to a ZnO target of 6 inches (15.24 cm) in diameter, and each of the remaining substrates In the deposition chamber of the sputtering apparatus was heated to maintained at 450 °C, where a D.C. power of 1 Kw was applied to the ZnO target for 180 seconds to form an about 1000 nm thick ZnO layer as the transparent electrically conductive layer 3 on the back reflecting layer 2 of each substrate. After this, all the substrates each having the back reflecting layer 2 and the transparent electrically conductive layer 3 formed in this order thereon were taken out from the sputtering apparatus. One of these substrates was observed by means of the scanning electron microscope with respect to its surface state. As a result, the surface of the transparent electrically conductive layer 3 of the substrate was found to have irregularities with an average top-to-valley elevation of about 200 nm which is greater than that of the back reflecting layer 2.

On the transparent electrically conductive layer 3 of each of the substrates having the back reflecting layer 2 and the transparent electrically conductive layer 3 formed in this order thereon, the semiconductor junction layer 4 was formed using the film-forming apparatus shown in FIG. 5 as will be described below.

The substrates 1 having the back reflecting layer 2 and the transparent electrically conductive layer 3 formed in this order thereon were spacedly arranged on a transportation jig 32 in a load and unload chamber 31 of the film-forming apparatus shown in FIG. 5. The transportation jig 32 comprises a substrate holder (not shown) structured so that it can hold thereon a specimen (a substrate) so as to face in a downward direction and it can be moved up and down. And the substrate holder is provided with an opening through which the specimen held thereon is exposed to a film-forming space of a film-forming chamber, where a desired film can be formed on the specimen by the film-forming chamber.

The film-forming apparatus is structured so that the transportation jig 32 can be moved by means of conveying means 32' therein.

### Formation of Semiconductor Layer 4A:

After the load and unload chamber 31 was evacuated until 10⁻⁴ Torr by means of a vacuum pump (not shown) connected to an exhaust pipe (not shown) communicated with the inside of the load and unload chamber 31, a gate valve 33 was opened, and the transportation jig 32 having the substrate holder with the substrates 1 (each having the back reflecting layer 2 and the transparent electrically conductive layer 3 formed in this order thereon) held thereon was moved to a position above an n-type layer-forming space 34-1 of a first film-forming chamber 34 which is situated under a substrate temperature controlling means 35. The gate valve 33 was closed, the substrate holder was press-descended by means of the substrate temperature controlling means 35 such that a distance between each substrate and a counter electrode 44 situated on the lower side of the n-type layer-forming space 34-1 was 30 mm, and the surface of each substrate was controlled to have a temperature of 250 °C by means of the substrate temperature controlling means 35. In this case, a gate valve 38 situated to opposite the gate valve 33 through the film-forming chamber 34 was also closed. Then, after the film-forming chamber 34 including the n-type layer-forming space 34-1 was sufficiently evacuated by means of a vacuum pump (not shown) connected to an exhaust pipe (not shown) which is communicated with the inside of the film-forming chamber 34 and is provided with a throttle valve (not shown), Si₂H₆ gas, PH₃/H₂ gas (PH₃ diluted by H₂ to 2 %) and H₂ gas were introduced into the n-type layer-forming space 34-1 through a gas feed pipe 49 extending from a raw material gas supply system comprising a gas reservoir 49-1 containing Si₂H₆ gas, a gas reservoir 49-2 containing PH₃/H₂ gas (PH₃ diluted by H₂ to 2 %) and a gas reservoir 49-3 containing H₂ gas at respective flow rates of 1 sccm, 0.5 sccm and 48 sccm. Then, the opening of the throttle valve provided at the exhaust pipe connected to the film-forming chamber 34 was adjusted to maintain the inner pressure of the n-type layer-forming space 34-1 at 1 Torr, and a high frequency power (13.56 MHz) of 1.8 W from a high frequency power source with an oscillation frequency of 13.56 MHz (not shown) was supplied to the counter electrode 44 to cause glow discharge in the n-type layer-forming space 34-1 for 3 minutes. By this, there was formed an about 20 nm thick n-type semiconductor layer containing no crystalline phase as the first semiconductor layer 4A on the transparent electrically conductive layer 3 of each substrate 1.

### Formation of Semiconductor Layer 4B:

After the formation of the semiconductor layer 4A, the operation of the substrate temperature controlling means 35, the introduction of the raw material gases and the application of the high frequency power were terminated. And the substrate temperature controlling means 35 was lifted and the film-forming chamber 34 was sufficiently evacuated by means of the vacuum pump. Then, the transportation jig 32 having the substrate holder with the substrates 1 having the first semiconductor layer 4A formed thereon was moved to a position right above an i-type layer-forming space 34-2 of the first film-forming chamber 34 which is situated under a substrate temperature controlling means 36. The substrate bolder was press-descended by means of the substrate temperature controlling means 36 such that a distance between each substrate and a counter electrode 45 situated on the lower side of the i-type layer-forming space 34-2 was 30 mm, and the surface of each substrate was controlled to have a temperature of 270 °C by means of the substrate temperature controlling means 36. Then, after the film-forming chamber 34 including the i-type layer-forming space 34-2 was sufficiently evacuated by means of the vacuum pump, Si₂H₆ gas and H₂ gas were introduced into the i-type layer-forming space 34-2 through a gas feed pipe 50 extending from a raw material gas supply system comprising a gas reservoir 50-1 containing Si₂H₆ gas and a gas reservoir 50-2 containing H₂ gas at respective flow rates of 4 sccm, and 100 sccm. Then, the opening of the throttle valve provided at the exhaust pipe connected to the film-forming chamber 34 was adjusted to maintain the inner pressure of the i-type layer-forming space 34-2 at 0.5 Torr, and a high frequency power (13.56 MHz) of 2 W from a high frequency power source with an oscillation frequency of 13.56 MHz (not shown) was supplied to the counter electrode 45 to cause glow discharge in the i-type layer-forming space 34-2 for 80 seconds. By this, there was formed an about 25 nm thick i-type semiconductor layer containing no crystalline phase, which becomes to be the second semiconductor layer 4B, on the first semiconductor layer 4A of each substrate 1.

After the formation of the i-type semiconductor layer on each substrate, the operation of the substrate temperature controlling means 36, the introduction of the raw material gases and the application of the high frequency power were terminated. And the substrate temperature controlling means 36 was lifted and the film-forming chamber 34 was sufficiently evacuated by means of the vacuum pump. Then, the gate valve 38 and a gate valve 41 were opened, and the transportation jig 32 having the substrate holder with the substrates 1 having the i-type semiconductor layer formed thereon was moved into a laser processing chamber 42 while passing through a second film-forming chamber 39, where the substrate holder was positioned right under a substrate temperature controlling means 43 which is structured so that it can be moved in a direction for the substrate holder to be transported. After the gate valve 41 was closed, the substrate holder was press-descended until a prescribed position by means of the substrate temperature controlling means 43, and the surface of each substrate (that is, the surface of the i-type semiconductor layer of each substrate) on the substrate holder was controlled to have a temperature of 200 °C by means of the substrate temperature controlling means 43. After the laser processing chamber 42 was sufficiently evacuated by means of a vacuum pump (not shown) connected to an exhaust pipe (not shown) which is communicated with the inside of the laser processing chamber 42 and is provided with a throttle valve (not shown), H₂ gas was introduced into the laser processing chamber 42 through a gas feed pipe 53 connected to a raw material gas supply system comprising a gas reservoir 53-1 containing H₂ gas at a flow rate of 500 sccm. After this, the inner pressure of the laser processing chamber 42 was maintained at about 10 Torr by adjusting the opening of the throttle valve provided at the exhaust pipe connected to the laser processing chamber 42. Then, using a conventional xenon-chlorine type eximer laser 56, laser beam with a wavelength of about 308 nm, a pulse width of 13 nsec and 30 pulses per sec was irradiated from the lower side of the laser processing chamber 42 through a quartz glass window 54 applied with non-reflection treatment to the surface thereof, while controlling the energy density at 150 mJ/cm². Particularly, by adjusting the optical system so that an irradiation region at each substrate surface per one pulse became to be of a dimension of about 3 mm (length) x 3 mm (width) and traveling a reflection mirror 55 in a direction perpendicular to the transportation direction of the substrate holder with the substrates, the laser beam was irradiated to the surface of each substrate (that is, the surface of the i-type semiconductor layer of each substrate) on the substrate holder at a scanning speed of 9 mm/sec, where the irradiation position was shifted little by little so that about 90 % of a given irradiation region was overlapped with the successive irradiation region. In this case, the reflection mirror 55 was moved in aforesaid direction by 2.2 mm for every scanning using a stepping motor. By performing the laser beam irradiation scanning 20 times, the substantially entire surface of each substrate could be laser-processed.

In the above, the commencement and termination of the laser irradiation, the scanning of the reflection mirror, and the transportation of the substrate bolder with the substrates were controlled using a personal computer.

By the manner described in the above, substantially only the i-type semiconductor layer of each substrate could be microcrystallized to have a structure containing approximately spherical microcrystalline phases having a varied average size distribution such that said spherical microcrystalline phases on the laser irradiated side have an average size which is greater than that of said spherical microcrystalline phases on the side of the first semiconductor layer 4A, whereby the second semiconductor layer 4B was formed on the first semiconductor layer 4A of each substrate.

For confirmation purposes, one substrate prior to subjecting to the laser processing and another substrate subjected to the laser processing were taken out from the film-forming apparatus. And each of them was subjected to analysis using a conventional argon laser Raman spectroscopic ultramicroanalyzer. As a result, the i-type semiconductor layer prior to subjecting to the laser processing was found to be a non-crystalline layer having a Raman spectrum broadened centering at about 480/cm. On the other hand, the layer obtained by subjecting the i-type semiconductor layer to the laser processing was found to have a Raman spectrum with a sharp peak of about 520/cm. Based on this result, it was confirmed that the layer obtained by subjecting the i-type semiconductor layer to the laser processing was microcrystallized.

### Formation of Third Semiconductor Layer 4C:

For the remaining substrates having the second semiconductor layer 4B formed thereon situated on the substrate holder, the third semiconductor layer 4C was formed on the second semiconductor layer 4B of each substrate as will be described below.

After the formation of the second semiconductor layer 4B, the operation of the substrate temperature controlling means 43, the operation of the eximer laser 56 and the introduction of the H₂ gas were terminated. And the substrate temperature controlling means 43 was lifted, and the laser processing chamber 42 was sufficiently evacuated by means of the vacuum pump. After this, the gate valve 41 was opened. Then, the transportation jig 32 having the substrate holder with the substrates having the second semiconductor layer 4B formed thereon was moved into the second film-forming chamber 39, where the substrate holder was positioned right under a substrate temperature controlling means 40. Thereafter, the gate valves 38 and 41 were closed, and the substrate bolder was press-descended by means of the substrate temperature controlling means 40 until a prescribed position. Then, the surface of each substrate (that is, the surface of the second semiconductor layer 4B of each substrate) was controlled to have a temperature of 350 °C by means of the substrate temperature controlling means 40. Then, after the film-forming chamber 39 was sufficiently evacuated by means of a vacuum pump (not shown) connected to an exhaust pipe (not shown) which is communicated with the inside of the film-forming chamber 39 and is provided with a throttle valve (not shown), SiF₄ gas and H₂ gas were introduced into the film-forming chamber 39 through a gas feed pipe 52 extending from a raw material gas supply system comprising a gas reservoir 52-1 containing SiF₄ gas end a gas reservoir 52-2 containing H₂ gas at respective flow rates of 80 sccm and 240 sccm. Then, the opening of the throttle valve provided at the exhaust pipe connected to the film-forming chamber 39 was adjusted to maintain the inner pressure of the film-forming chamber 39 at 0.1 Torr, and a microwave power of 200 W was introduced into the film-forming chamber 39 through an applicator 47 electrically connected to a microwave power source of 2.45 GHz (not shown) through a waveguide 48 to cause glow discharge in the film-forming chamber 39 for 20 minutes. By this, there was formed an about 1000 nm thick i-type semiconductor layer containing pillar microcrystalline phases as the third semiconductor layer 4C on the second semiconductor layer 4B of each substrate.

After the formation of said i-type semiconductor layer as the third semiconductor layer 4C on the second semiconductor layer 4B of each substrate, the operation of the substrate temperature controlling means 40, the introduction of the raw material gases and the introduction of the microwave power were terminated.

For confirmation purposes, one of the substrates situated on the substrate holder was taken out from the film-forming apparatus, and the i-type semiconductor layer formed thereon as the third semiconductor layer 4C was subjected to X-ray diffraction analysis. As a result, there was observed a peak at a region of about 47.5° which is corresponding to (220) plane of Si. Similarly, it was subjected to analysis using the foregoing Raman spectroscopic ultramicroanalyzer. As a result, there was observed a peak at a region of about 516/cm. These results indicate that the i-type semiconductor layer contains microcrystalline phases.

Further, a cross section of the layered structure of the substrate was examined by means of a transmission electron microscope. As a result, there were obtained the following facts. That is, the first semiconductor layer 4A was found to comprise a semiconductor material with no crystalline phase in which any microcrystalline phase with a size of 5 nm or more is not observed at all. For the second semiconductor layer 4B, it was found that the approximately spherical microcrystalline phases situated on the side of the first semiconductor layer 4A have an average size of about 5 nm and the approximately spherical microcrystalline phases situated on the side of the third semiconductor layer 4C have an average size of about 10 nm. For the pillar microcrystalline phases of the third semiconductor layer 4C, it was found that longer ones of them have a length which is near the layer thickness and a width of about 50 nm. Further, it was found that a layer region of the third semiconductor layer 4C in the vicinity of the second semiconductor layer 4B contains also approximately spherical microcrystalline phases having an average size of about 50 nm mingled together with the pillar microcrystalline phases.

### Formation of Fourth Semiconductor Layer 4D:

For remaining substrates having the third semiconductor layer 4C formed thereon situated on the substrate holder, the fourth semiconductor layer 4D was formed on the third semiconductor layer 4C of each substrate as will be described below.

After the substrate temperature controlling means 40 was lifted and the second film-forming chamber 39 was sufficiently evacuated by means of the vacuum pump, the gate valve 38 was opened. Then, the transportation jig 32 having the substrate holder with the substrates having the third semiconductor layer 4C formed thereon was moved to return to a position right above the i-type layer-forming space 34-2 of the first film-forming chamber 34 which is situated under the substrate temperature controlling means 36. After this, the gate valve 38 was closed. Then, the substrate holder was press-descended by means of the substrate temperature controlling means 36 such that a distance between each substrate and the counter electrode 45 situated on the lower side of the i-type layer-forming space 34-2 was 30 mm, and the surface of each substrate (that is, the surface of the third semiconductor layer 4C of each substrate) was controlled to have a temperature of 270 °C by means of the substrate temperature controlling means 36. Then, after the film-forming chamber 34 including the i-type layer-forming space 34-2 was sufficiently evacuated by means of the vacuum pump, Si₂H₆ gas and H₂ gas were introduced into the i-type layer-forming space 34-2 through the gas feed pipe 50 at respective flow rates of 4 sccm and 100 sccm. Then, the opening of the throttle valve provided at the exhaust pipe connected to the film-forming chamber 34 was adjusted to maintain the Inner pressure of the i-type layer-forming space 34-2 at 0.5 Torr, and a high frequency power (13.56 MHz) of 2 W from the high frequency power source with an oscillation frequency of 13.56 MHz (not shown) was supplied to the counter electrode 45 to cause glow discharge in the i-type layer-forming space 34-2 for 2 minutes. By this, there was formed an about 40 nm thick i-type semiconductor layer as the fourth semiconductor layer 4D on the third semiconductor layer 4C of each substrate.

After the formation of the fourth semiconductor layer 4D on the third semiconductor layer 4C of each substrate, the operation of the substrate temperature controlling means 36, the introduction of the raw material gases and the application of the high frequency power were terminated.

### Formation of Fifth Semiconductor Layer 4E:

The substrate temperature controlling means 36 was lifted and the film-forming chamber 34 was sufficiently evacuated by means of the vacuum pump. Then, the transportation jig 32 having the substrate holder with the substrates having the fourth semiconductor layer 4D formed thereon was moved to a position right above a p-type layer-forming space 34-3 of the first film-forming chamber 34 which is situated under a substrate temperature controlling means 37. The substrate holder was press-descended by means of the substrate temperature controlling means 37 such that a distance between each substrate and a counter electrode 46 situated on the lower side of the p-type layer-forming space 34-3 was 30 mm, and the surface of each substrate (that is, the surface of the fourth semiconductor layer 4D of each substrate) was controlled to have a temperature of 165 °C by means of the substrate temperature controlling means 37. Then, after the film-forming chamber 34 including the p-type layer-forming space 34-3 was sufficiently evacuated by means of the vacuum pump, H₂ gas was introduced into the p-type layer-forming space 34-3 through a gas feed pipe 51 extending from a raw material gas supply system comprising a gas reservoir 51-1 containing SiH₄/H₂ gas (SiH₄ diluted by H₂ to 10%), a gas reservoir 51-2 containing BF₃/H₂ gas (BF₃ diluted by H₂ to 2%) and a gas reservoir 51-3 containing H₂ gas at a flow rate of 85 sccm, and the opening of the throttle valve provided at the exhaust pipe connected to the film-forming chamber 34 was adjusted to maintain the inner pressure of the p-type layer-forming space 34-3 at 2 Torr. When the inner pressure of the p-type layer-forming space 34-3 became stable at this vacuum value, a high frequency power (13.56 MHz) of 33 W from a high frequency power source with an oscillation frequency of 13.56 MHz (not shown) was supplied to the counter electrode 46 to cause glow discharge in the p-type layer-forming space 34-3 for 30 seconds, whereby the surface of the fourth semiconductor layer 4D of each substrate was plasma-processed. After the application of the high frequency power was suspended, SiH₄/H₂ gas (SiH₄ diluted by H₂ to 10%), BF₃/H₂ gas (BF₃ diluted by H₂ to 2%) and H₂ gas were introduced into the p-type layer-forming space 34-3 at respective flow rates of 0.25 sccm, 1 sccm and 35 sccm through the gas feed pipe 51. Then, the opening of the throttle valve provided at the exhaust pipe connected to the film-forming chamber 34 was adjusted to maintain the inner pressure of the p-type layer-forming space 34-3 at 2 Torr. When the inner pressure of the p-type layer-forming space 34-3 became stable at this vacuum value, a high frequency power (13.56 MHz) of 44 W from the high frequency power source with an oscillation frequency of 13.56 MHz (not shown) was supplied to the counter electrode 46 to cause glow discharge in the p-type layer-forming space 34-3 for 150 seconds. By this, there was formed an about 10 nm thick p-type semiconductor layer containing crystalline materials as the fifth second semiconductor layer 4E on the fourth semiconductor layer 4D of each substrate. Thus, the semiconductor junction layer 4 was formed on each substrate.

After the formation of the fifth semiconductor layer 4E on each substrate, the operation of the substrate temperature controlling means 37, the introduction of the raw material gases and the application of the high frequency power were terminated.

The thickness of each of the constituent layers was obtained by a manner wherein for a layered product whose constituent layers having been formed respectively under prescribed conditions, a step formed when a part of each constituent layer is removed is measured by a stylus type film thickness-measuring device and the measured result is converted in terms of a time spent for the formation thereof.

After the formation of the fifth semiconductor layer 4E on each substrate, the substrate temperature controlling means 37 was lifted and the gate valve 33 was opened. Then, the transportation jig 32 having the substrate holder with the substrates having the back reflecting layer 2, the transparent electrically conductive layer 3 and the semiconductor junction layer 4 formed in this order thereon was moved into the load and unload chamber 31, where the substrates were unloaded from the transportation jig 32 and they were taken out from the film-forming chamber.

Thus, there were obtained a plurality of layered products each comprising the back reflecting layer 2, the transparent electrically conductive layer 3 and the semiconductor junction layer 4 (comprising the first to fifth semiconductor layers 4A-4E) stacked in this order on the substrate 1.

### Formation of Upper Electrode Layer:

On the fifth semiconductor layer 4E of each of the layered products obtained in the above, the upper electrode layer 5 was formed using a DC magnetron sputtering apparatus as will be described below.

Each layered product was fixed onto the surface of an anode of the DC magnetron sputtering apparatus and the surrounding of the layered product was shielded by a stainless steel mask such that a central area of the surface of the fifth semiconductor layer 4E was exposed, and film formation was conducted using an ITO (comprising 10 % by weight of SnO₂ and 90 % by weight of In₂O₃) under conditions of 170 °C for the substrate temperature, 50 sccm for the flow rate of inert gas comprising Ar gas, 0.5 sccm for the flow rate of oxygen gas. 3 mTorr for the inner pressure of the deposition chamber, 0.2 W/cm² for the an electric power applied per a unit are of the target, and 100 seconds for the deposition time, whereby an about 70 nm thick ITO film as the upper electrode layer 5 was deposited on said exposed central area of the surface of the fifth semiconductor layer 4E. The conditions for the thickness of the ITO film to be formed were based on a previously established calibration curve.

Thus, there were obtained a plurality of photovoltaic elements having such constitution as shown in the photovoltaic element 100 (see, FIGs. 1 to 3).

For each of the resultant photovoltaic elements, there was formed a collecting electrode 6 (a grid electrode) on the upper electrode layer 5 thereof by arranging a copper wire coated by a carbon paste over the surface of the upper electrode layer 5, followed by subjecting to thermocompression bonding.

Then, a tin foil tape as the positive power output terminal 7B was fixed to the collecting electrode 6 using an electrically conductive adhesive. And a copper tub as the negative power output terminal 7A was fixed to the substrate 1.

Here, for each of the photovoltaic elements thus prepared, in order to facilitate power output wiring in the preparation of a photovoltaic element module which will be described later, the positive power output terminal 7B was extended to the rear face side of the photovoltaic element through an insulating member so that it can be extended together with the negative power output terminal 7A to the outside through an opening formed at a back face reinforcing member 10 which will be described later.

### 2. Preparation of Photovoltaic Element Module:

Using each of the photovoltaic elements obtained in the above, there were prepared a plurality of photovoltaic element modules having such configuration as shown in FIG. 1.

Each photovoltaic element module was prepared as will be described below.

On the light receiving face side of the photovoltaic element, a 460 µm thick EVA sheet having a thickness of (trademark name: PHOTOCAP, produced by Spring Born Laboratories Company) as the sealing material 8 and a 50 µm thick non-oriented ETFE film having a corona-discharged surface (trademark name: TEFZEL, produced by Du Pont Company) as the surface protective film 9 were laminated in this order, followed by laminating a 460 µm thick EVA sheet having a thickness of (trademark name: PHOTOCAP, produced by Spring Born Laboratories Company) as the sealing material 8, a 63.5 µm thick nylon film (trademark name: DARTEK, produced by Du Pont Company) as the insulating member 11, and a 0.27 mm thick galvanized steel plate (Zn-plated steel plate) (which is provided with an opening through which a pair of power output terminals of the photovoltaic element can be extended to the outside after the completion of production of a photovoltaic element module) as the back face reinforcing member 10 in this order on the non-light receiving face side of the photovoltaic element, whereby a stacked body comprising the ETFE film/the EVA sheet/the photovoltaic element/the EVA sheet/the nylon film/the galvanized steel plate was obtained. In this case, an aluminum mesh member of 16 x 18 meshes [line diameter: 0.11 inch (0.27 mm)] was arranged on the outside of the ETFE film as the surface protective film through a 50 µm thick Teflon film (trademark name: Teflon PFA film, produced by Du Pont Company) which facilitates removal of the aluminum mesh member from a protruded portion of the EVA which will be occurred in successive vacuum lamination treatment.

The stacked body was subjected to thermocompression bonding at 150 °C for 30 minutes using a vacuum laminater, followed by cooling. After this, the aluminum mesh member was removed together with the Teflon film. And the pair of the power output terminals of the photovoltaic element were together extended to the outside through the opening of the back face reinforcing member. By this, there was obtained a photovoltaic element module having a front surface provided with irregularities based on the aluminum mesh member. In this way, there were prepared a plurality of photovoltaic element modules.

The above mentioned EVA sheet is one which has been widely using as a sealing material for a solar cell (a photovoltaic element). The EVA sheet is an EVA sheet comprised of an EVA resin (vinyl acetate content: 33%) incorporated with 1.5 parts by weight of a crosslinking agent, 0.3 part by weight of an UV absorber, 0.1 part by weight of a photo stabilizer, 0.2 part by weight of an antioxidant, and 0.25 part by weight of a silane coupling agent respectively versus 100 parts by weight of the EVA resin.

### Evaluation

For the resultant photovoltaic element modules, their I-V characteristics under irradiation of pseudo sunlight of AM 1.5 (100 mW/cm²) were measured. Based on the measured I-V characteristics, there were obtained a open-circuit voltage (Voc), a short-circuit current (Jsc), a fill factor (F.F.), and a photoelectric conversion efficiency (η) for each photovoltaic element module. And for all the photovoltaic element modules, their average open-circuit voltage (Voc), average short-circuit current (Jsc), average fill factor (F.F.), and average photoelectric conversion efficiency (η) were obtained. And their average open-circuit voltage (Voc), average short-circuit current (Jsc), average fill factor (F.F.), and average photoelectric conversion efficiency (η) were 0.96, 1.16, 0.99 and 1.11, which are normalized values when those of the photovoltaic elements modules obtained in Comparative Example 1A which will be described later are respectively set at 1.00.

Separately, their average open-circuit voltage (Voc), average short-circuit current (Jsc), average fill factor (F.F.), and average photoelectric conversion efficiency (η) after having subjected to irradiation of pseudo sunlight of AM 1.5 (100 mW/cm²) for 1000 hours were 0.96, 1.15, 0.99, and 1.16.

The evaluated results obtained are collectively shown in Table 1.

Based on the above results, it is understood that the characteristics of any of the photovoltaic element modules of this example are not substantially deteriorated even when exposed to irradiation of light over a long period of time.

Hence, it is understood that for the photovoltaic element modules obtained in this example, their short-circuit current and fill factor are improved, their short-circuit voltage is satisfactory, their light deterioration is slight, and thus, they excel in total viewpoints with respect to characteristics.

Further, the photovoltaic element modules of this example were subjected to environmental test for 1000 hours using an environmental test box with temperature of 85 °C and humidity of 85%. As a result, their photoelectric conversion efficiency was decreased only by 0.02 %. which is not problematic in practice.

### Example 2

The procedures of Example 1 were repeated, except that the energy density of the laser beam in the formation of the second semiconductor layer 4B was changed to 200 mJ/cm², to obtain a plurality of photovoltaic element modules.

In the course of forming the semiconductor junction layer 4, as well as in the case of Example 1, cross section observation by means of the transmission electron microscope was conducted. As a result, there were obtained results which are substantially the same as those obtained in Example 1. That is, no crystalline phase was observed in the first semiconductor layer 4A. For the second semiconductor layer 4B, it was found to have approximately spherical microcrystalline phases on the side of the third semiconductor layer 4C which have an average size which is greater than that of approximately spherical microcrystalline phases situated on the side of the first semiconductor layer 4A. For the third semiconductor layer 4C, it was found to have a pillar microcrystalline structure.

For the photovoltaic element modules obtained in this example, evaluation was conducted with their characteristics in the same manner as in Example 1. As a result, their average open-circuit voltage (Voc), average short-circuit current (Jsc), average fill factor (F.F.), and average photoelectric conversion efficiency (η) on the basis of their I-V characteristics under irradiation of pseudo sunlight of AM 1.5 (100 mW/cm²) were 0.95, 1.13, 1.00, and 1.08, which are normalized values when those of the photovoltaic elements modules obtained in Comparative Example 1A which will be described later are respectively set at 1.00.

These characteristics of the photovoltaic element modules of this example were not substantially changed even when the photovoltaic element modules were subjected to irradiation of pseudo sunlight of AM 1.5 (100 mW/cm²) for 1000 hours.

The evaluated results obtained are collectively shown in Table 1.

Further, the photovoltaic element modules of this example were subjected to environmental test for 1000 hours using an environmental test box with temperature of 85 °C and humidity of 85%. As a result, their photoelectric conversion efficiency was decreased only by 0.01 %, which is not problematic in practice.

### Comparative Example 1A

The procedures of Example 1 were repeated, except that in the formation of the second semiconductor layer 4B, the i-type semiconductor layer was not subjected to laser annealing treatment, to obtain a plurality of photovoltaic element modules.

In the course of forming the semiconductor junction layer 4, at the stage where the formation of the second semiconductor layer 4B was conducted, one substrate was taken out and the second semiconductor layer 4B formed thereon was examined by way of X-ray diffraction analysis. As a result, there was not observed any peak corresponding to a silicon crystalline phase. Further, as a result of having examined by way of Raman spectroscopic analysis, there was observed merely a smooth mountain at a region of 480/cm. Based on this, the second semiconductor layer 4B was found to have no crystalline phase. In addition, one substrate for which were formed until the fifth semiconductor layer 4E was taken out, and its cross section was examined using a transmission electron microscope. As a result, presence of pillar microcrystalline phases was observed in the third semiconductor layer 4C but no crystalline phase was observed for the second semiconductor layer 4B. It is a matter of course that no spherical microcrystalline phase was not observed for the second semiconductor layer 4B.

For the photovoltaic element modules obtained in this comparative example, evaluation was conducted with their characteristics in the same manner as in Example 1. As a result, their average open-circuit voltage (Voc), average short -circuit current (Jsc), average fill factor (F.F.), and average photoelectric conversion efficiency (η) on the basis of their I-V characteristics under irradiation of pseudo sunlight of AM 1.5 (100 mW/cm²) were made to be 1.00, 1.00, 1.00, and 1.00, respectively. The evaluated results are collectively shown in Table 1.

And their average short-circuit current (Jsc), average fill factor (F.F.), and average photoelectric conversion efficiency (η) after having subjected to irradiation of pseudo sunlight of AM 1.5 (100 mW/cm²) for 1000 hours were 1.00, 1.02, 0.94, and 0.95.

### Comparative Example 1B

The procedures of Example 1 were repeated, except that the energy density of the laser beam in the formation of the second semiconductor layer 4B was changed to 300 mJ/cm², to obtain a plurality of photovoltaic element modules.

During the preparation of the photovoltaic element, one substrate for which were formed until the fifth semiconductor layer 4E was taken out, and its cross section was examined using a transmission electron microscope. As a result, no clear distinction was observed for the first and second semiconductor layers 4A-4B and presence of large crystalline particles having a magnitude of exceeding about 20 nm was observed in both the first semiconductor layer 4A and the second semiconductor layer 4B. It is considered that this situation would be occurred as a result of the matching between the two semiconductor layers having been deteriorated due to excessive annealing for the i-type semiconductor layer in the formation of the second semiconductor layer 4B.

For the photovoltaic element modules obtained in this comparative example, evaluation was conducted with their characteristics in the same manner as in Example 1. As a result, their average open-circuit voltage (Voc), average short-circuit current (Jsc), average fill factor (F.F.), and average photoelectric conversion efficiency (η) on the basis of their I-V characteristics under irradiation of pseudo sunlight of AM 1.5 (100 mW/cm²) were 0.99, 1.05, 1.01, and 1.05, which are normalized values when those of the photovoltaic elements modules obtained in Comparative Example 1A are respectively set at 1.00.

And their average short-circuit current (Jsc), average fill factor (F.F.), and average photoelectric conversion efficiency (η) after having subjected to irradiation of pseudo sunlight of AM 1.5 (100 mW/cm²) for 1000 hours were 0.85, 0.96, 0.80, and 0.65, which are markedly inferior to the initial characteristics.

The evaluated results obtained are collectively shown in Table 1.

### Example 3

The procedures of Example 1 were repeated, except that the second semiconductor layer 4B was formed by changing the deposition time (80 seconds in Example 1) for the i-type semiconductor layer in the formation of the second semiconductor layer 4B to 32 seconds, 145 seconds, and 180 seconds, to obtain a plurality of photovoltaic element modules.

For the photovoltaic element modules obtained in this example, evaluation was conducted with their characteristics in the same manner as in Example 1. The evaluated results obtained are collectively shown in Table 2.

### Comparative Example 2A

The procedures of Example 1 were repeated, except that without forming the i-type semiconductor layer for the second semiconductor layer 4B, the first semiconductor layer 4A was subjected to laser-annealing in the same manner as in the case of forming the second semiconductor layer 4B in Example 1, to obtain a plurality of a plurality of photovoltaic element modules.

For the photovoltaic element modules obtained in this comparative example, evaluation was conducted with their characteristics in the same manner as in Example 1. The evaluated results obtained are collectively shown in Table 2.

### Comparative Example 2B

The procedures of Example 1 were repeated, except that the second semiconductor layer 4B was formed by changing the deposition time (80 seconds in Example 1) for the i-type semiconductor layer in the formation of the second semiconductor layer 4B to 215 seconds, to obtain a plurality of photovoltaic element modules.

For the photovoltaic element modules obtained in this comparative example, evaluation was conducted with their characteristics in the same manner as in Example 1. The evaluated results obtained are collectively shown in Table 2.

### Example 4

The procedures of Example 1 were repeated, except that the second semiconductor layer 4B was formed in a manner as will be described in the following, to obtain a plurality of photovoltaic element modules.

In Example 1, after the formation of the about 20 nm thick n-type semiconductor layer containing no crystalline phase as the first semiconductor layer 4A on the transparent electrically conductive layer 3 of each substrate by the n-type layer forming space 34-1, the operation of the substrate temperature controlling means 35, the introduction of the raw material gases and the application of the high frequency power were terminated. Thereafter, the film-forming chamber 34 was sufficiently evacuated by means of the vacuum pump. And the surface of each substrate (that is, the surface of the first semiconductor layer 4A of each substrate) on the substrate holder was controlled to have a temperature of 310 °C by means of the substrate temperature controlling means 35. Then, after the film-forming chamber 34 including the n-type layer-forming space 34-1 was sufficiently evacuated by means of the vacuum pump, SiH₄/H₂ gas (SiH₄ diluted by H₂ to 10%), PH₃/H₂ gas (PH₃ diluted by H₂ to 2%) and H₂ gas were introduced into the n-type layer-forming space 34-1 through the gas feed pipe 49 extending from the raw material gas supply system comprising the gas reservoir 49-1 containing SiH₄/H₂ gas (SiH₄ diluted by H₂ to 10%), the gas reservoir 49-2 containing PH₃/H₂ gas (PH₃ diluted by H₂ to 2%) and the gas reservoir 49-3 containing H₂ gas at respective flow rates of 4 sccm, 0.5 sccm and 50 sccm. Then, the opening of the throttle valve provided at the exhaust pipe connected to the film-forming chamber 34 was adjusted to maintain the inner pressure of the n-type layer-forming space 34-1 at 1 Torr, and a high frequency power (13.56 MHz) of 15 W from the high frequency power source with an oscillation frequency of 13.56 MHz (not shown) was supplied to the counter electrode 44 to cause glow discharge in the n-type layer-forming space 34-1 for 80 seconds. By this, there was formed an about 13 nm thick n-type semiconductor layer containing small approximately spherical microcrystalline phases on the first semiconductor layer 4A of each substrate.

Then, the introduction of the raw material gases and the application of the high frequency power were suspended, and the film-forming chamber 34 including the n-type layer-forming space 34-1 was sufficiently evacuated by means of the vacuum pump. Thereafter. SiH₄/H₂ gas (SiH₄ diluted by H₂ to 10%), PH₃/H₂ gas (PH₃ diluted by H₂ to 2%) and H₂ gas were introduced into the n-type layer-forming space 34-1 through the gas feed pipe 49 at respective flow rates of 4 sccm, 0.5 sccm and 100 sccm. Then, the opening of the throttle valve provided at the exhaust pipe connected to the film-forming chamber 34 was adjusted to maintain the inner pressure of the n-type layer-forming space 34-1 at 1 Torr, and a high frequency power (13.56 MHz) of 15 W from the high frequency power source with an oscillation frequency of 13.56 MHz (not shown) was supplied to the counter electrode 44 to cause glow discharge in the n-type layer-forming space 34-1 for 120 seconds. By this, there was formed an about 13 nm thick n-type semiconductor layer containing large approximately spherical microcrystalline phases on the previously formed n-type semiconductor layer of each substrate.

For the resultant two-layered semiconductor layer comprising the above two n-type semiconductor layers, such laser-annealing as in Example 1 was not conducted.

Thus, the second semiconductor layer 4B comprising the above two n-type semiconductor layers was formed on the first semiconductor layer 4A of each substrate.

In this example, in the course of forming the second semiconductor layer 4B, by increasing the hydrogen dilution ratio, the two-layered microcrystalline layer as the second semiconductor layer 4B was made such that the two constituent microcrystalline layers were different one from the other in terms of the average size for their constituent microcrystalline phases.

For confirmation purposes, one substrates for which were formed until the second semiconductor layer 4B taken out from the film-forming apparatus, and it was subjected to analysis using a conventional argon laser Raman spectroscopic ultramicroanalyzer. As a result, the the second semiconductor layer 4B was found to have a Raman spectrum with a sharp peak of about 520/cm. Based on this result, it was confirmed that the second semiconductor layer 4B contains microcrystalline phases.

After the formation of the second semiconductor layer 4B on each substrate, the transportation jig 32 having the substrate holder with the remaining substrates for which were formed until the second semiconductor layer 4B was moved into the second film-forming chamber 39, where the third semiconductor layer 4C was formed on the second semiconductor layer 4B of each substrate in the same manner as in Example 1.

For confirmation purposes, one of the substrates situated on the substrate holder was taken out from the film-forming apparatus, and the third semiconductor layer 4C was subjected to X-ray diffraction analysis. As a result, there was observed a peak at a region of about 47.5° which is corresponding to (220) plane of Si. Similarly, it was subjected to analysis using the foregoing Raman spectroseopic ultramicroanalyzer. As a result, there was observed a peak at a region of about 516/cm. These results indicate that the third semiconductor layer 4C contains microcrystalline phases.

Further, a cross section of the layered structure of the substrate was examined by means of a transmission electron microscope. As a result, there were obtained the following facts. That is, the first semiconductor layer 4A was found to comprise a semiconductor material with no crystalline phase in which any microcrystalline phase with a size of 5 nm or more is not observed at all. For the second semiconductor layer 4B, it was found that the approximately spherical microcrystalline phases situated on the side of the first semiconductor layer 4A have an average size of about 5 nm and the approximately spherical microcrystalline phases situated on the side of the third semiconductor layer 4C have an average size of about 10 nm. For the pillar microcrystalline phases of the third semiconductor layer 4C, it was found that longer ones of them have a length which is near the layer thickness and a width of about 50 nm. Further, it was found that a layer region of the third semiconductor layer 4C in the vicinity of the second semiconductor layer 4B contains also approximately spherical microcrystalline phases having an average size of about 50 nm mingled together with the pillar microcrystalline phases.

For the photovoltaic element modules obtained in this example, evaluation was conducted with their characteristics in the same manner as in Example 1. As a result, their average open-circuit voltage (Voc), average short-circuit current (Jsc), average fill factor (F.F.), and average photoelectric conversion efficiency (η) on the basis of their I-V characteristics under irradiation of pseudo sunlight of AM 1.5 (100 mW/cm²) were 0.97, 1.11, 0.99, and 1.08, which are normalized values when those of the photovoltaic elements modules obtained in Comparative Example 1A are respectively set at 1.00.

And their average short-circuit current (Jsc), average fill factor (F.F.), and average photoelectric conversion efficiency (η) after having subjected to irradiation of pseudo sunlight of AM 1.5 (100 mW/cm²) for 1000 hours were 0.97, 1.10, 0.99, and 1.10, which are almost the same as the initial characteristics.

Further, the photovoltaic element modules of this example were subjected to environmental test for 1000 hours using an environmental test box with temperature of 85 °C and humidity of 85%. As a result, their photoelectric conversion efficiency was decreased only by 0.02 %, which is not problematic in practice.

### Example 5

The procedures of Example 1 were repeated, except that the second semiconductor layer 4B was formed in a manner as will be described in the following, to obtain a plurality of photovoltaic element modules.

In Example 1, after the formation of the about 20 nm thick n-type semiconductor layer containing no crystalline phase as the first semiconductor layer 4A on the transparent electrically conductive layer 3 of each substrate by the n-type layer forming space 34-1, the operation of the substrate temperature controlling means 35, the introduction of the raw material gases and the application of the high frequency power were terminated. Thereafter, the film-forming chamber 34 was sufficiently evacuated by means of the vacuum pump. And the surface of each substrate (that is, the surface of the first semiconductor layer 4A of each substrate) on the substrate holder was controlled to have a temperature of 270 °C by means of the substrate temperature controlling means 35. Then, after the film-forming chamber 34 including the n-type layer-forming space 34-1 was sufficiently evacuated by means of the vacuum pump, SiH₄/H₂ gas (SiH₄ diluted by H₂ to 10%), PH₃/H₂ gas (PH₃ diluted by H₂ to 2%) and H₂ gas were introduced into the n-type layer-forming space 34-1 through the gas feed pipe 49 extending from the raw material gas supply system comprising the gas reservoir 49-1 containing SiH₄/H₂ gas (SiH₄ diluted by H₂ to 10%), the gas reservoir 49-2 containing PH₃/H₂ gas (PH₃ diluted by H₂ to 2%) and the gas reservoir 49-3 containing H₂ gas at respective flow rates of 4 sccm, 0.5 sccm and 100 sccm. Then, the opening of the throttle valve provided at the exhaust pipe connected to the film-forming chamber 34 was adjusted to maintain the inner pressure of the n-type layer-forming space 34-1 at 1 Torr, and a high frequency power (13.56 MHz) of 15 W from the high frequency power source with an oscillation frequency of 13.56 MHz (not shown) was supplied to the counter electrode 44 to cause glow discharge in the n-type layer-forming space 34-1 for 80 seconds. By this, there was formed an about 13 nm thick n-type semiconductor layer containing small approximately spherical microcrystalline phases on the first semiconductor layer 4A of each substrate.

Then, the surface of each substrate (that is, the surface of the previously formed n-type semiconductor layer of each substrate) on the substrate holder was controlled to have a temperature of 350 °C by means of the substrate temperature controlling means 35 while maintaining the above film-forming conditions except for suspending the application of the high frequency power. Successively, a high frequency power (13.56 MHz) of 15 W from the high frequency power source with an oscillation frequency of 13.56 MHz was supplied to the counter electrode 44 to cause glow discharge in the n-type layer-forming space 34-1 for 120 seconds. By this, there was formed an about 13 nm thick n-type semiconductor layer containing large approximately spherical microcrystalline phases on the previously formed n-type semiconductor layer of each substrate.

For the resultant two-layered semiconductor layer comprising the above two n-type semiconductor layers, such laser-annealing as in Example 1 was not conducted.

Thus, the second semiconductor layer 4B comprising the above two n-type semiconductor layers was formed on the first semiconductor layer 4A of each substrate.

In this example, in the course of forming the second semiconductor layer 4B, by increasing the hydrogen dilution ratio, the two-layered microcrystalline layer as the second semiconductor layer 4B was made such that the two constituent microcrystalline layers were different one from the other in terms of the average size for their constituent microcrystalline phases.

For confirmation purposes, one substrates for which were formed until the second semiconductor layer 4B taken out from the film-forming apparatus, and it was subjected to analysis using the conventional argon laser Raman spectroscopic ultramicroanalyzer. As a result, the the second semiconductor layer 4B was found to have a Raman spectrum with a sharp peak of about 520/cm. Based on this result, it was confirmed that the second semiconductor layer 4B contains microcrystalline phases.

After the formation of the second semiconductor layer 4B on each substrate, the transportation jig 32 having the substrate holder with the remaining substrates for which were formed until the second semiconductor layer 4B was moved into the second film-forming chamber 39, where the third semiconductor layer 4C was formed on the second semiconductor layer 4B of each substrate in the same manner as in Example 1.

For confirmation purposes, one of the substrates situated on the substrate holder was taken out from the film-forming apparatus, and the third semiconductor layer 4C was subjected to X-ray diffraction analysis. As a result, there was observed a peak at a region of about 47.5° which is corresponding to (220) plane of Si. Similarly, it was subjected to analysis using the foregoing Raman spectroscopic ultramicroanalyzer. As a result, there was observed a peak at a region of about 516/cm. These results indicate that the third semiconductor layer 4C contains microcrystalline phases.

Further, a cross section of the layered structure of tile substrate was examined by means of a transmission electron microscope. As a result, there were obtained the following facts. That is, the first semiconductor layer 4A was found to comprise a semiconductor material with no crystalline phase in which any microcrystalline phase with a size of 5 nm or more is not observed at all. For the second semiconductor layer 4B, it was found that the approximately spherical microcrystalline phases situated on the side of the first semiconductor layer 4A have on average size of about 5 nm and the approximately spherical microcrystalline phases situated on the side of the third semiconductor layer 4C have an average size of about 10 nm. For the pillar microcrystalline phases of the third semiconductor layer 4C, it was found that longer ones of them have a length which is near the layer thickness and a width of about 50 nm. Further, it was found that a layer region of the third semiconductor layer 4C in the vicinity of the second semiconductor layer 4B contains also approximately spherical microcrystalline phases having an average size of about 50 nm mingled together with the pillar microcrystalline phases.

For the photovoltaic element modules obtained in this example, evaluation was conducted with their characteristics in the same manner as in Example 1. As a result, their average open-circuit voltage (Voc), average short-circuit current (Jsc), average fill factor (F.F.), and average photoelectric conversion efficiency (η) on the basis of their I-V characteristics under irradiation of pseudo sunlight of AM 1.5 (100 mW/cm²) were 0.98, 1.10, 0.99, and 1.07, which are normalized values when those of the photovoltaic elements modules obtained in Comparative Example 1A are respectively set at 1.00.

And their average short-circuit current (Jsc), average fill factor (F.F.), and average photoelectric conversion efficiency (η) after having subjected to irradiation of pseudo sunlight of AM 1.5 (100 mW/cm²) for 1000 hours were 0.98. 1.09, 0.99, end 1.06, which are almost the same as the initial characteristics.

Further, the photovoltaic element modules of this example were subjected to environmental test for 1000 hours using an environmental test box with temperature of 85 °C and humidity of 85%. As a result, their photoelectric conversion efficiency was decreased only by 0.02 %, which is not problematic in practice.

As will be understood from the above description, according to the present invention, there can be attained a high performance photovoltaic element (solar cell) in which a large quantity of an electric current is generated even when its semiconductor junction layer is relatively thin end which exhibits an improved photoelectric conversion efficiency whose rate of change is a little over a long period of time. The use of this photovoltaic element (solar cell) enables one to establish a desirable building material and a desirable sunlight power generation apparatus which have characteristics whose rate of change is a little over a long period of time.

Further, because even when the semiconductor junction layer is relatively thin, there can be attained a desirable photovoltaic element (solar cell), the time required for the formation of the semiconductor junction layer in the production of a photovoltaic element (solar cell), a desirable photovoltaic element (solar cell) can be produced at a reasonable production cost.

**Table 1**

| | laser power (mJ/cm²) | open-circuit voltage | short circuit current | fill factor | photoelectric conversion efficiency |
|---|---|---|---|---|---|
| Comparative Example 1A | 0 | 1.00 | 1.00 | 1.00 | 1.00 |
| Example 1 | 150 | 0.96 | 1.16 | 0.99 | 1.11 |
| Example 2 | 200 | 0.95 | 1.18 | 1.00 | 1.08 |
| Comparative Example 1B | 300 | 0.85 | 0.96 | 0.80 | 0.65 |

**Table 2**

| | deposition time of the second semiconductor layer (sec.) | open-circuit voltage | short circuit current | fill factor | photoelectric conversion efficiency |
|---|---|---|---|---|---|
| Comparative Example 2A | 0 | 0.99 | 1.01 | 0.99 | 1.00 |
| Example 3 | 32 | 0.97 | 1.10 | 1.00 | 1.08 |
| Example 3 | 145 | 0.95 | 1.13 | 1.00 | 1.08 |
| Example 3 | 180 | 0.94 | 1.11 | 0.98 | 1.03 |
| Comparative Example 2B | 215 | 0.91 | 1.08 | 0.98 | 0.97 |

A photovoltaic element having a stacked structure comprising a first semiconductor layer containing no crystalline phase, a second semiconductor layer containing approximately spherical microcrystalline phases, and a third semiconductor layer containing pillar microcrystalline phases which are stacked in this order, wherein said spherical microcrystalline phases of said second semiconductor layer on the side of said third semiconductor layer have an average size which is greater than that of said spherical microcrystalline phases of said second semiconductor layer on the side of said first semiconductor layer.

## Claims

1. A photovoltaic element having a stacked structure comprising a first semiconductor layer containing no crystalline phase, a second semiconductor layer containing approximately spherical microcrystalline phases, and a third semiconductor layer containing pillar microcrystalline phases which are stacked in this order, wherein said spherical microcrystalline phases of said second semiconductor layer on the side of said third semiconductor layer have an average size which is greater than that of said spherical microcrystalline phases of said second semiconductor layer on the side of said first semiconductor layer.

2. A photovoltaic element according to claim 1, wherein each of said first semiconductor layer, said second semiconductor layer and said third semiconductor layer comprises a hydrogen-containing silicon material, a hydrogen-containing silicon-germanium material, a hydrogen-containing silicon carbide material, or a mixture of these as a main constituent.

3. A photovoltaic element having a stacked structure comprising a first semiconductor layer containing no crystalline phase, a second semiconductor layer containing approximately spherical microcrystalline phases, and a third semiconductor layer containing pillar microcrystalline phases which are stacked in this order, wherein said third semiconductor layer has a layer region containing approximately spherical microcrystalline phases mingled together with said pillar microcrystalline phases in the vicinity of said second semiconductor layer.

4. A photovoltaic element according to claim 3, wherein each of said first semiconductor layer, said second semiconductor layer and said third semiconductor layer comprises a hydrogen-containing silicon material, a hydrogen-containing silicon-germanium material, a hydrogen-containing silicon carbide material, or a mixture of these as a main constituent.

5. A process for producing a photovoltaic element, comprising the steps of:
(a) forming a first semiconductor layer containing no crystalline phase but containing a desired amount of a doping element on a substrate,
(b) forming a second semiconductor layer containing no crystalline phase and containing no doping element or a trace amount of a doping element on said first semiconductor layer to obtain a layered product,
(c) laser-annealing said layered product from the side of said second semiconductor layer side by way of irradiation of laser beam with a desired intensity to microcrystallize only said second semiconductor layer so as to contain approximately spherical microcrystalline phases such that said spherical microcrystalline phases situated on the laser-irradiated side have an average size which is greater than that of said spherical microcrystalline phases situated on the side of said first semiconductor layer, and
(d) forming a third semiconductor layer containing pillar microcrystalline phases on said microcrystallized second semiconductor layer.

6. A process for producing a photovoltaic element according to claim 5, wherein said laser beam is irradiated at an intensity of 100 to 250 mJ/cm².

7. A process for producing a photovoltaic element according to claim 5, wherein said second semiconductor layer is formed at a deposition time of 30 to 200 seconds.

8. A process for producing a photovoltaic element, comprising the steps of:
(a) forming a first semiconductor layer containing no crystalline phase on a substrate,
(b) forming a second semiconductor layer containing approximately spherical microcrystalline phases on said first semiconductor layer, and
(c) forming a third semiconductor layer containing pillar microcrystalline phases on said second semiconductor layer, wherein in the course of forming said second semiconductor layer in the step (b), a dilution ratio of a film-forming raw material by a hydrogen gas is increased to form said spherical microcrystalline phases contained in said second semiconductor layer such that said spherical microcrystalline phases situated on the side of said third semiconductor layer have an average size which is greater than that of said spherical microcrystalline phases situated on the side of said first semiconductor layer.

9. A process for producing a photovoltaic element, comprising the steps of:
(a) forming a first semiconductor layer containing no crystalline phase on a substrate,
(b) forming a second semiconductor layer containing approximately spherical microcrystalline phases on said first semiconductor layer, and
(c) forming a third semiconductor layer containing pillar microcrystalline phases on said second semiconductor layer, wherein in the course of forming said second semiconductor layer in the step (b), a temperature of forming said second semiconductor layer is increased to form said spherical microcrystalline phases contained in said second semiconductor layer such that said spherical microcrystalline phases situated on the side of said third semiconductor layer have an average size which is greater than that of said spherical microcrystalline phases situated on the side of said first semiconductor layer.

10. A building material having a photovoltaic element defined in claim 1, characterized in that said photovoltaic element and a back face reinforcing member are integrally sealed.

11. A power generation apparatus comprising a photovoltaic element defined in claim 1 and a power converting means for converting a power generated by said photovoltaic element into a desired power.
